# EUROPEAN PATENT APPLICATION

(11) **EP 4 593 546 A2**
(43) Date of publication of application: **30.07.2025**
(21) Application number: 25153277.6
(22) Date of filing: 22.01.2025
(51) Int. Cl.: H10B 41/10, H10B 41/27, H10B 41/50, H10B 43/10, H10B 43/27, H10B 43/50

(54) **SEMICONDUCTOR DEVICES AND DATA STORAGE SYSTEMS INCLUDING THE SAME**

(30) Priority: 23.01.2024 KR 20240010368
(71) Applicant: Samsung Electronics Co., Ltd., Suwon-si, Gyeonggi-do 16677 (KR)
(72) Inventor: CHUNG, Soochan, 16677 Suwon-si (KR); KIM, Pyeongwoo, 16677 Suwon-si (KR); PARK, Hyungha, 16677 Suwon-si (KR); LEE, Gilsung, 16677 Suwon-si (KR); LEE, Chanyang, 16677 Suwon-si (KR); CHAE, Jiwoong, 16677 Suwon-si (KR); HWANG, Hyunyoung, 16677 Suwon-si (KR)
(74) Representative: Marks & Clerk LLP

(57) **Abstract**

A semiconductor device may include a stack structure including gate electrodes stacked in a vertical direction; a cell guide structure on the stack structure and defining a first region of the stack structure; a first conductive layer on the stack structure in the first region and in contact with the cell guide structure; a protective layer on a region of the stack structure; and channel structures each including a first portion and a second portion, the first portion penetrating the stack structure in the vertical direction and the second portion extending upwardly from the first portion and including a channel layer in direct contact with the first conductive layer. A side surface of the first conductive layer and a lower surface of the first conductive layer may form an acute angle on an interfacial surface between the first conductive layer and the cell guide structure.

## Description

### BACKGROUND

Example embodiments of the present disclosure relate to a semiconductor device and a data storage system including the same.

A semiconductor device able to store high-capacity data in a data storage system requiring data storage has been necessary. Accordingly, a method for increasing data storage capacity of a semiconductor device has been researched. For example, as a method for increasing data storage capacity of a semiconductor device, a semiconductor device including memory cells disposed three-dimensionally, instead of memory cells disposed two-dimensionally, has been suggested.

### SUMMARY

An example embodiment of the present disclosure provides a semiconductor device having improved reliability.

An example embodiment of the present disclosure provides a data storage system including a semiconductor device having a semiconductor device having improved reliability.

According to an example embodiment of the present disclosure, a semiconductor device may include a first semiconductor structure including a first substrate, circuit devices on the first substrate, a lower interconnection structure electrically connected to the circuit devices, and a lower bonding structure connected to the lower interconnection structure; and a second semiconductor structure connected to the first semiconductor structure and on the first semiconductor structure. The second semiconductor structure may include a stack structure including interlayer insulating layers and gate electrodes stacked vertically in a first region of the stack structure and a second region of the stack structure, an upper interconnection structure below the stack structure, an upper bonding structure connected to the upper interconnection structure and bonded to the lower bonding structure, a cell guide structure on an upper portion of the stack structure and dividing the first region of the stack structure and the second region of the stack structure, channel structures each including a first portion and a second portion, the first portion penetrating the stack structure in a vertical direction in the first region of the stack structure, and the second portion extending upwardly from the first portion in the first region of the stack structure, contact plugs penetrating the stack structure in the vertical direction and being connected to contact regions of the gate electrodes in the second region of the stack structure, a first conductive layer in contact with an internal side surface of the cell guide structure in the first region of the stack structure, the first conductive layer on an upper portion of the stack structure and connected to the second portion of the channel structures, and a protective layer in contact with an external side surface of the cell guide structure in the second region of the stack structure, the protective layer being on the upper portion of the stack structure.

According to an example embodiment of the present disclosure, a semiconductor device may include a stack structure including interlayer insulating layers and gate electrodes stacked in a vertical direction, the stack structure including a first region and a second region; a cell guide structure on the stack structure and defining the first region of the stack structure; a first conductive layer on the stack structure in the first region of the stack structure and in contact with the cell guide structure; a protective layer on the second region of the stack structure; and channel structures each including a first portion and a second portion, the first portion penetrating the stack structure in the vertical direction and the second portion extending upwardly from the first portion and including a channel layer in direct contact with the first conductive layer, the channel structures being on the first region of the stack structure. A side surface of the first conductive layer and a lower surface of the first conductive layer may form an acute angle on an interfacial surface between the first conductive layer and the cell guide structure.

According to an example embodiment of the present disclosure, a data storage system may include a semiconductor storage device and a controller. The semiconductor storage device may include a first semiconductor structure including a substrate and circuit devices on the substrate, and a second semiconductor structure including a stack structure and an input/output pad. The stack structure may include interlayer insulating layers and gate electrodes stacked in a vertical direction in a first region and a second region of the stack structure. The stack structure may further include channel structures each including a first portion and a second portion, the first portion penetrating the stack structure in the vertical direction in the first region of the stack structure and the second portion extending upwardly from the first portion in the first region of the stack structure. The input/output pad may be electrically connected to the circuit devices. The controller may be electrically connected to the semiconductor storage device through the input/output pad and configured to control the semiconductor storage device. The first semiconductor structure may further include a lower interconnection structure electrically connected to the circuit devices and a lower bonding structure connected to the lower interconnection structure. The second semiconductor structure may include an upper interconnection structure below the stack structure, an upper bonding structure connected to the upper interconnection structure and bonded to the lower bonding structure, a cell guide structure on an upper portion of the stack structure and dividing the first region of the stack structure and the second region of the stack structure, contact plugs penetrating the stack structure in the vertical direction and being connected to contact regions of the gate electrodes in the second region of the stack structure, a first conductive layer in contact with an internal side surface of the cell guide structure in the first region of the stack structure, the first conductive layer on an upper portion of the stack structure and connected to the second portion of the channel structure, and a protective layer in contact with an external side surface of the cell guide structure in the second region of the stack structure, the protective layer being on the upper portion of the stack structure.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan view illustrating a semiconductor device according to an example embodiment of the present disclosure;
FIG. 2 is a plan view illustrating a mat in FIG. 1;
FIG. 3 is an enlarged plan view illustrating a semiconductor device according to an example embodiment of the present disclosure;
FIGS. 4A and 4B are cross-sectional views illustrating a semiconductor device according to example embodiments of the present disclosure;
FIGS. 5A and 5B are enlarged cross-sectional views illustrating a portion of a region in FIG. 4B;
FIGS. 6A and 6B are enlarged views illustrating a semiconductor device according to example embodiments of the present disclosure;
FIGS. 7 to 9A are cross-sectional views illustrating a semiconductor device according to example embodiments of the present disclosure;
FIG. 9B is an enlarged cross-sectional view illustrating region "D" in FIG. 9A;
FIG. 10 is a plan view illustrating a semiconductor device according to example embodiments of the present disclosure;
FIGS. 11 and 12 are cross-sectional views illustrating a semiconductor device according to example embodiments of the present disclosure;
FIGS. 13A to 13O are cross-sectional views illustrating a method of manufacturing a semiconductor device according to example embodiments of the present disclosure;
FIG. 14 is a diagram illustrating a data storage system including a semiconductor device according to an example embodiment of the present disclosure;
FIG. 15 is a perspective view illustrating a data storage system including a semiconductor device according to an example embodiment of the present disclosure; and
FIG. 16 is a cross-sectional view illustrating a semiconductor package according to an example embodiment of the present disclosure.

### DETAILED DESCRIPTION

Hereinafter, embodiments of the present disclosure will be described as follows with reference to the accompanying drawings.

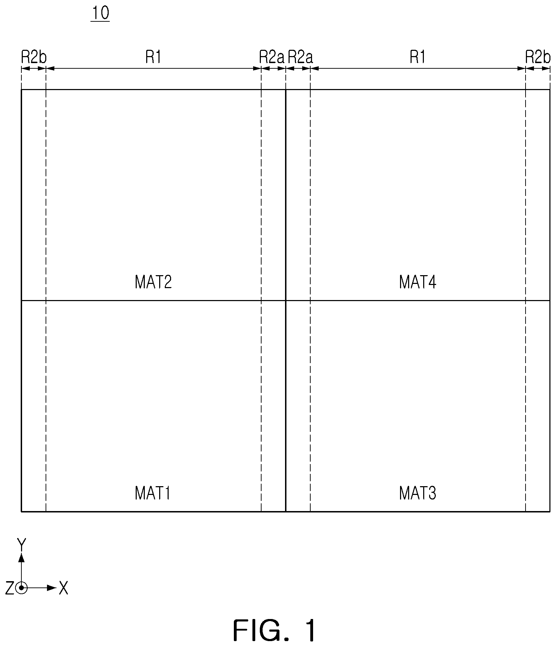

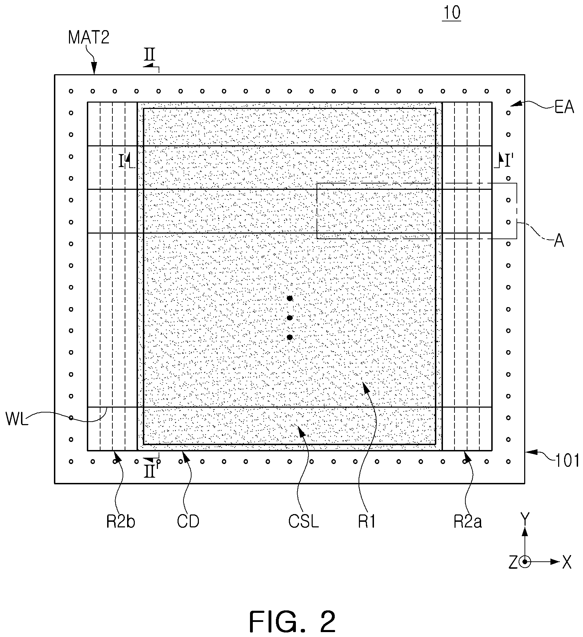

FIG. 1 is a plan view illustrating a semiconductor device according to an example embodiment. FIG. 2 is a plan view illustrating a mat in FIG. 1. FIG. 2 illustrates a second mat, one of four mats in FIG. 1. In these and other figures, directions X, Y, Z are defined. It will be understood that these are example directions, expressed relative to the device.

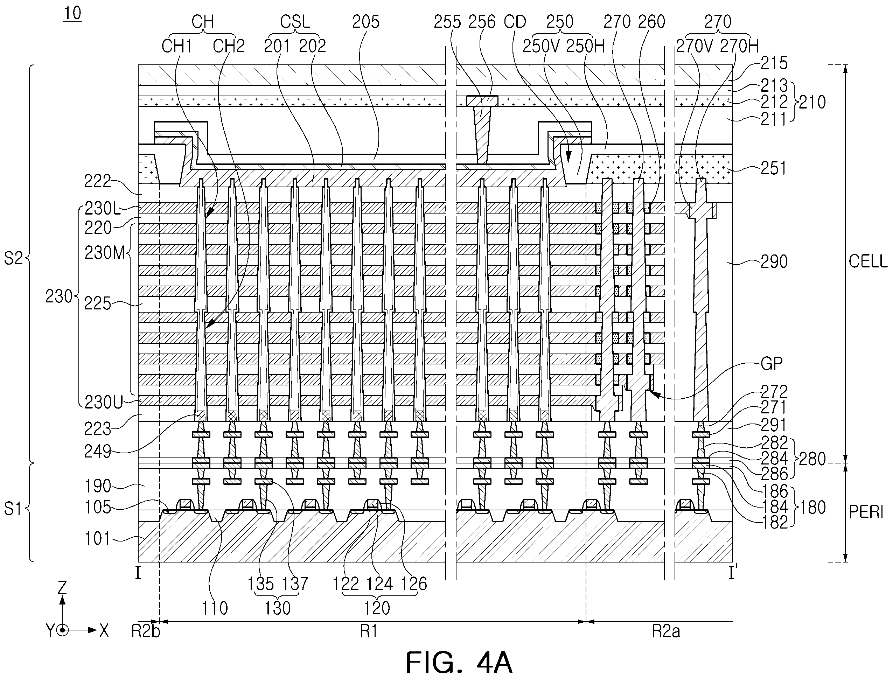

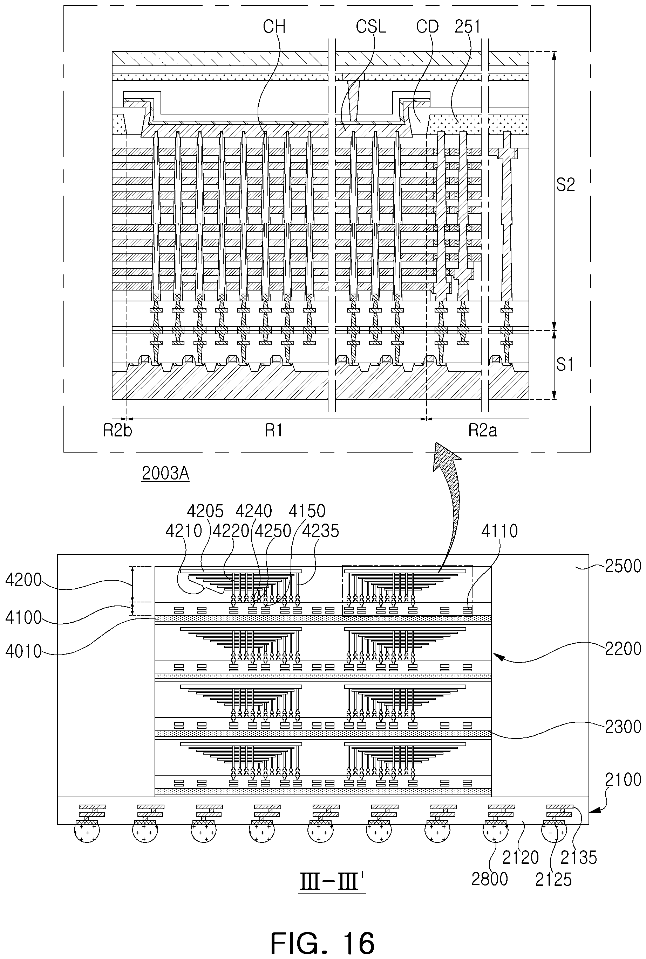

The semiconductor device 10 may include a first semiconductor structure S1 and a second semiconductor structure S2 (see FIGS. 4A and 16), and the first semiconductor structure S1 may be stacked in the Z-direction, which is a vertical direction with respect to the second semiconductor structure S2. Specifically, the first semiconductor structure S1 may be disposed in a lower portion of the second semiconductor structure S2 in the Z-direction. In example embodiments, alternatively, the second semiconductor structure S2 may be disposed in a lower portion of the first semiconductor structure S1.

In an example embodiment, the semiconductor device 10 may include a peripheral circuit structure PERI (see FIG. 4A), the first semiconductor structure S1 in which a peripheral circuit region is formed on the first substrate 101, and memory cell structure CELL, the second semiconductor structure S2 including the common source line CSL (see FIG. 4A).

In an example embodiment, the first semiconductor structure S1 may form a peripheral circuit by forming transistors and a metal pattern for interconnecting the transistors on the first substrate 101. After the peripheral circuit is formed in the first semiconductor structure S1, the second semiconductor structure S2 may be formed, but an example embodiment thereof is not limited thereto.

The second semiconductor structure S2 of the semiconductor device 10 may include a plurality of mats MAT1-MAT4. The mats MAT1-MAT4 may be arranged in matrix type in the X-direction and the Y-direction.

As an example, an n number of mats MAT1-MATn may be disposed for a single semiconductor device 10. For example, four or eight mats MAT1-MATn may be disposed. For example, when four mats MAT1-MAT4 are disposed, the mat in the lower left side may be defined as a first mat MAT1, and the other mats may be defined as a second mat MAT2 extending in the Y-direction with the first mat MAT1, a third mat MAT3 extending in the X-direction with the first mat MAT1, and a fourth mat MAT4 extending in the Y-direction with the third mat MAT3. Each of the mats MAT1-MAT4 may include memory blocks BLK, which include a plurality of channel structures CH.

Each of the mats MAT1-MAT4 may include a first region R1, and a first extension region R2a and a second extension region R2b on both sides of the first region R1 in the X-direction.

The first extension region R2a may be configured as an extension region disposed between neighboring mats MAT 1-MAT4, and the second extension region R2b may be defined as an extension region disposed on an external side of the semiconductor device 10. Accordingly, the first extension regions R2a of the first mat MAT1 and the third mat MAT3 may face each other, the first extension regions R2a of the second mat MAT2 and the fourth mat MAT4 may face each other, and the second extension regions R2b may be disposed on an external side of each side (left and right sides) of the semiconductor device 10. The first region R1 may be a memory cell region in which memory cells are disposed, and channel structures CH are disposed in the first region R1, and the first extension region R2a and the second extension region R2b may be regions for electrically connecting the memory cells to the peripheral circuit structures PERI, and to this end, gate electrode layers may extend to different lengths in the first extension region R2a and the second extension region R2b, but an example embodiment thereof is not limited thereto.

Referring to FIG. 2, the mats MAT1-MAT4 may have an edge region EA disposed on each side. The edge region EA may be disposed on an external side of the first extension region R2a, an external side of second extension region R2b, and may be disposed on and below the first region R1, and a mold structure may remain in the edge region EA. The edge region EA may be defined as a region in which a pad region connected from an external entity is disposed, external contact vias connected to the pad region are disposed, or various through-vias connected to the first semiconductor structure S1 are disposed. The edge region EA may be disposed on each side of each of the mats MAT1-MAT4 and may have a frame shape, but an example embodiment thereof is not limited thereto.

Each of the mats MAT1-MAT4 may further include a cell guide structure CD defining the first region R1 on the stack structures GS1 and GS2 and mold structures MS1 and MS2.

The cell guide structure CD may define the first region R1, a memory cell region in which the channel structures CH are disposed, on each of the mats MAT1-MAT4, and may define a region in which the common source line CSL is disposed. Accordingly, the memory cell region may be defined on an internal side of the cell guide structure CD, the edge region EA is defined above and below the first region R1 on an external side of the cell guide structure CD, and the first and second extension regions R2a and R2b may be disposed on the left and right sides of the first region R1, on an X-Y plane. The common source line CSL may be disposed in a plate shape in the cell guide structure CD, or may be disposed in several isolated units.

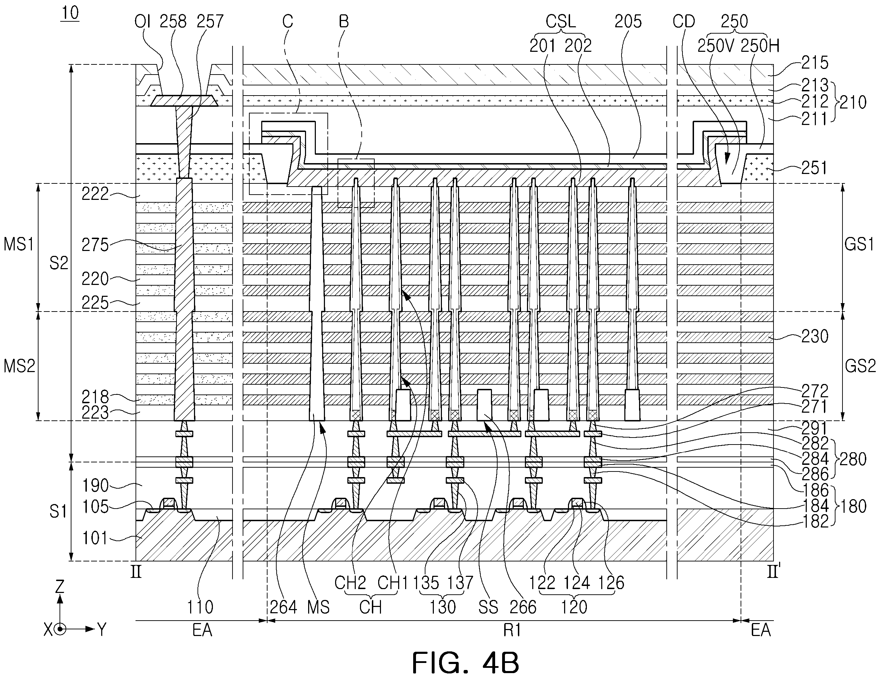

The common source line CSL may not be disposed on an external side of the cell guide structure CD, and a protective layer 251 may be disposed (see for example Figures 4A and 4B). The protective layer 251 may be a nitride film, specifically a silicon nitride film, and H-rich SiN, that is, a nitride film including a substantial amount of hydrogen, may be applied. H-rich SiN may be applied as PE-SiN (plasma enhanced-SiN), and may be a material layer having relatively low thermal conductivity, high energy absorption, and reduced thermal stress change, and may function as a buffer layer. While a melting laser annealing process (MLA) is performed on the semiconductor layer included in the common source line CSL, it may not be possible to perform a selective processing, such that energy and heat may be transmitted into the first and second extension regions R2a and R2b and the edge region EA in which the lower interconnections are formed, such that device defects may occur due to unintended metal migration of a copper material forming the lower interconnections. Accordingly, while performing crystallization and planarization on the semiconductor layer in the cell guide structure CD through a melting laser annealing process, by disposing a protective layer 251 on the neighboring first and second extension regions R2a and R2b and the edge region EA to reduce the influence downwardly, the lower interconnections may be protected.

The cell guide structure CD may have a frame shape having a desired and/or alternatively predetermined width on the X-Y plan, and the desired and/or alternatively predetermined width may have a width of 5 to 10 times a width of an upper end of the channel structure CH. For example, the cell guide structure CD may have a width of 500 to 1000 nm, or a width of 800 to 1000 nm, but an example embodiment thereof is not limited thereto.

By disposing the cell guide structure CD defining the first region R1, the memory cell region of each of the mats MAT1-MAT4, on the stack structures GS1 and GS2 or the mold structures MS1 and MS2, and disposing the common source line CSL into a plate shape only in the cell guide structure CD, the same effect as performing selective laser annealing may be obtained.

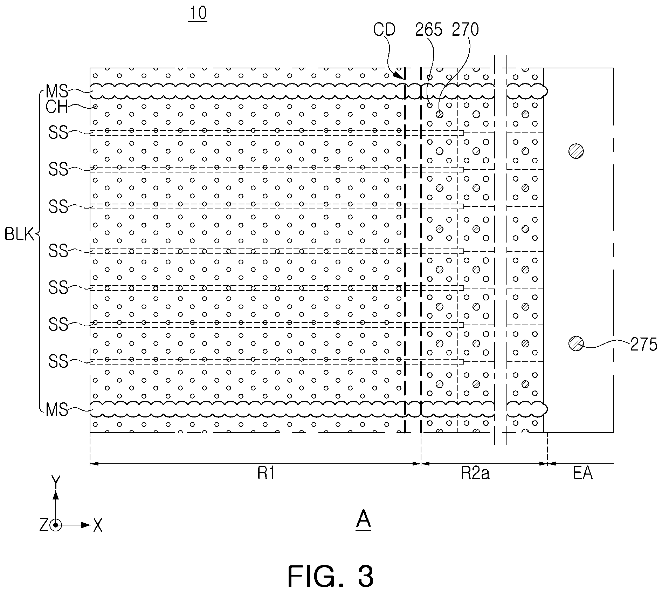

Hereinafter, an example embodiment will be described in greater detail with reference to FIGS. 3, 4A, 4B, and 5A and 5B.

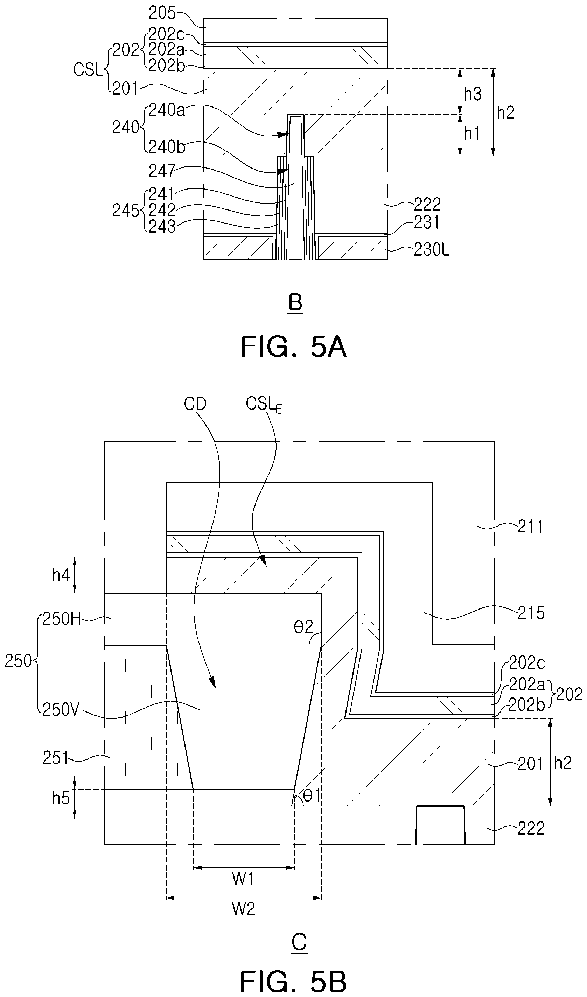

FIG. 3 is an enlarged view illustrating a semiconductor device according to an example embodiment. FIGS. 4A and 4B are views illustrating a semiconductor device according to example embodiments. FIGS. 5A and 5B are enlarged views illustrating a portion of a region in FIG. 4B. FIG. 3 is an enlarged view illustrating portion "A" in FIG. 2, and FIGS. 4A and 4B are cross-sectional views taken along lines I-I' and II-II' in FIG. 2, respectively. FIGS. 5A and 5B are enlarged views illustrating portion "B" and portion "C" in FIG. 4B, respectively.

Referring to FIGS. 3 to 5B, the semiconductor device 10 may include a first semiconductor structure S1 defined as a peripheral circuit structure PERI and a second semiconductor structure S2 defined as a memory cell structure CELL on the first semiconductor structure S1. The first semiconductor structure S1 and the second semiconductor structure S2 may be bonded to each other through bonding structures 180 and 280.

The first semiconductor structure S1 may include a first substrate 101, circuit devices 120 on the first substrate 101, a lower interconnection structure 130, a lower bonding structure 180, and a lower capping layer 190.

The first substrate 101 may include a semiconductor material, such as a group IV semiconductor, a group III-V compound semiconductor, or a group II-VI compound semiconductor. The first substrate 101 may be provided as a bulk wafer or an epitaxial layer. In the first substrate 101, the active region may be defined by device isolation layers 110. Source/drain regions 105 including impurities may be disposed in a portion of the active region.

The circuit devices 120 may include a transistor. Each of the circuit devices 120 may include a circuit gate dielectric layer 122, a circuit gate electrode 124, a spacer layer 126 and a source/drain region 105. The source/drain regions 105 including impurities may be disposed in the first substrate 101 on both sides of the circuit gate electrode 124. Spacer layers 126 may be disposed on both sides of the circuit gate electrode 124. The circuit gate dielectric layer 122 may include silicon oxide, silicon nitride, or a high-x material. A high-κ material may be a dielectric material having a high dielectric constant relative to silicon dioxide. For instance, a high-k material may have a dielectric constant that is greater than that of silicon dioxide. The circuit gate electrode 124 may include at least one of doped silicon, titanium nitride (TiN), tantalum nitride (TaN), tungsten nitride (WN), titanium silicon nitride (TiSiN), tantalum silicon nitride (TaSiN), tungsten silicon nitride (WSiN), tungsten (W), copper (Cu), aluminum (Al), molybdenum (Mo), and ruthenium (Ru). For example, the circuit gate electrode 124 may include a doped polycrystalline silicon layer. According to the example embodiment, the circuit gate electrode 124 may include multiple layers, two or more layers.

The lower interconnection structure 130 may be electrically connected to the circuit gate electrodes 124 and the source/drain regions 105 of the circuit devices 120. The lower interconnection structure 130 may include lower contact plugs 135 and lower interconnection lines 137 in which at least one region has a line shape. A portion of the lower contact plugs 135 may be connected to the source/drain regions 105, and although not illustrated, the other portion of the lower contact plugs 135 may be connected to the circuit gate electrodes 124. The lower contact plugs 135 may electrically connect the lower interconnection lines 137 disposed on different levels from an upper surface of the first substrate 101 to each other. The lower interconnection structure 130 may include a conductive material, for example, tungsten (W), copper (Cu), aluminum (Al), and each component may further include a diffusion barrier including at least one of titanium (Ti), titanium nitride (TiN), tantalum (Ta), tantalum nitride (TaN), and tungsten nitride (WN). According to example embodiments, the number of layers of the lower contact plugs 135 and the lower interconnection lines 137 included in the lower interconnection structure 130 and the dispositional form thereof may be varied.

The lower bonding structure 180 may be connected to the lower interconnection structure 130. The lower bonding structure 180 may include a lower bonding via 182, a lower bonding pad 184, and a lower bonding insulating layer 186. The lower bonding via 182 may be connected to the lower interconnection structure 130. The lower bonding pad 184 may be connected to the lower bonding via 182. The lower bonding via 182 and the lower bonding pad 184 may include a conductive material, for example, tungsten (W), copper (Cu), aluminum (Al), and each component may further include a diffusion barrier. The lower bonding insulating layer 186 may also function as a diffusion barrier of the lower bonding pad 184 and may include at least one of silicon oxide, silicon nitride, silicon oxynitride, or silicon oxycarbide. The lower bonding insulating layer 186 may have a thickness less than a thickness of the lower bonding pad 184, but an example embodiment thereof is not limited thereto. The lower bonding structure 180 may be in direct contact with or bonded to the upper bonding structure 280 by hybrid bonding. For example, the lower bonding pad 184 may be in contact with and coupled to the upper bonding pad 284 by copper (Cu)-copper (Cu) bonding (copper-to-copper bonding), and the lower bonding insulating layer 186 may be in contact with and coupled to the upper bonding insulating layer 286 dielectric-to-dielectric bonding. The lower bonding structure 180 may provide an electrical connection path between the peripheral circuit structure PERI (S 1) and the memory cell structure CELL (S2) together with the upper bonding structure 280.

The lower capping layer 190 may be disposed on the first substrate 101 and may cover the circuit devices 120 and the lower interconnection structure 130. The lower capping layer 190 may include a plurality of insulating layers. The lower capping layer 190 may include an insulating material, such as silicon oxide, silicon nitride, silicon oxynitride, or silicon oxycarbide.

The second semiconductor structure S2 as a memory cell structure, may include a first conductive layer 201 in the first region R1, the memory cell region, a second conductive layer 202 on an upper surface of the first conductive layer 201, a buffer layer 205 on an upper surface of the second conductive layer 202, interlayer insulating layers 220 stacked on a lower surface of the first conductive layer 201 and alternately stacked with gate electrodes 230 in a first region R1, a first extension region R2a and a second extension region R2b, channel structures CH disposed to penetrate the gate electrodes 230, isolation regions MS extending in one direction by penetrating the gate electrodes 230, and insulating regions SS penetrating a portion of the gate electrodes 230. The second semiconductor structure S2 may surround the first region R1, the first extension region R2a and the second extension region R2b, may include an edge region EA, and may include interlayer insulating layers 220 and sacrificial insulating layers 218 alternately stacked in the edge region EA. A protective layer 251 disposed on the lowermost interlayer insulating layer 222 horizontally with the first conductive layer 201 in the first extension region R2a, the second extension region R2b and the edge region EA may be included, and an upper capping layer 290 and a buffer layer 205 covering the gate electrodes 230, the upper insulating structure 210 and the passivation layer 215 on the protective layer 251 may be further included.

The second semiconductor structure S2 may include studs 272 for electrical connection with the first semiconductor structure S1, an upper interconnection structure 271 below the stack structures GS1 and GS2, and an upper bonding structure 280 connected to the upper interconnection structure 271.

The second semiconductor structure S2 may further include support structures 265 in the first extension region R2a and the second extension region R2b, contact plugs 270 and external contact vias 275 in the edge region EA.

As illustrated in FIG. 3, in the first region R1, the gate electrodes 230 may be stacked spaced apart from each other in a vertical direction, for example, in the Z-direction, and channel structures CH may be disposed. The first extension region R2a and the second extension region R2b may be disposed on both sides of the first region R1 in the X-direction, and the contact plugs 270 connected to the gate electrodes 230, respectively, and electrically connecting the memory cells to the first semiconductor structure S1 may be disposed in the first extension region R2a and the second extension region R2b. In FIGS. 3 and 4A, the gate electrodes 230 may extend to different lengths to form contact pads GP for connection between each gate electrode 230 and the contact plugs 270, but an example embodiment thereof is not limited thereto.

Also, the edge region EA may be disposed on an external side surface of the first extension region R2a and the second extension region R2b and upper and lower portions of the first region R1, and pad regions 258 for transmitting a signal to and receiving a signal from an external entity may be disposed, external contact vias 275 transmitting a signal from an external entity to the first semiconductor structure S1 may be disposed. In the edge region EA, the gate electrodes 230 may not extend and the mold structures MS1 and MS2 in which the sacrificial insulating layers 218 and the interlayer insulating layers 220 are stacked may remain, and the external contact vias 275 may be connected to the lower first semiconductor structure S1 while being insulated from the mold structures MS1 and MS2.

In the first region R1, the first extension region R2a and the second extension region R2b and edge region EA, an insulating structure 210 may be disposed in an upper portion of the stack structures GS1 and GS2, and a passivation layer 215 may be disposed on the insulating structure 210.

The gate electrodes 230 may be vertically spaced apart from and stacked on a lower surface of the first conductive layer 201 and the protective layer 251 and may form the stack structures GS1 and GS2 together with the interlayer insulating layers 220. The stack structure GS1 and GS2 may include a plurality of stack structures GS1 and GS2 vertically stacked. In FIGS. 4A and 4B, the lower and upper stack structures GS1 and GS2 may be included, but an example embodiment thereof is not limited thereto, and three-stage to five-stage stack structure GS1-GSn may be included. However, in some example embodiments, the stack structure GS1-GSn may include a single stack structure.

The gate electrodes 230 may include at least one lower gate electrode 230L forming a gate of the ground select transistor, memory gate electrodes 230M forming the plurality of memory cells, and upper gate electrodes 230U forming gates of the string select transistors. Here, the lower gate electrode 230L and the upper gate electrodes 230U may be referred to as "lower gate electrode" and "upper gate electrode" with respect to the direction during the manufacturing process. An upper gate electrode 230U may be higher than a lower gate electrode 230L in the Z direction. Depending on capacity of the semiconductor device 10, the number of the memory gate electrodes 230M included in the memory cells may be determined. In example embodiments, the number of each of the upper and lower gate electrodes 230U and 230L may be one to two or more, and may have a structure the same as or different from that of the memory gate electrodes 230M. In an example embodiment, erase gate electrodes may be further disposed below the upper gate electrodes 230U. Also, a portion of the gate electrodes 230, for example, the memory gate electrodes 230M adjacent to the upper or lower gate electrodes 230U and 230L, may be dummy gate electrodes, but an example embodiment thereof is not limited thereto.

The gate electrodes 230 may be isolated from each other in the Y-direction by isolation regions MS extending continuously in the first region R1, the first extension region R2a and the second extension region R2b. The gate electrodes 230 between a pair of isolation regions MS may form a memory block BLK, but the range of the memory block BLK is not limited thereto. A portion of the gate electrodes 230, for example, the memory gate electrodes 230M, may form a layer in the memory block BLK.

The gate electrodes 230 may be vertically stacked and spaced apart from each other in the first region R1, the first extension region R2a and the second extension region R2b, may extend at different lengths from the first region R1 to the first extension region R2a and the second extension region R2b, and may form a step structure of a staircase shape in a portion of the first extension region R2a and the second extension region R2b, for example. The gate electrodes 230 may be disposed to have a step structure in the Y-direction. By the step structure, the gate electrodes 230 may have regions in which the lower gate electrode 230 may extend further than the upper gate electrode 230, and upper surfaces may be exposed from the interlayer insulating layers 220 and the other gate electrodes 230. The pad region GP may be one region of the gate electrode 230 disposed in the uppermost portion of each region among the gate electrodes 230 forming the stack structures GS1 and GS2 in the first extension region R2a and the second extension region R2b. The gate electrodes 230 may be connected to the contact plugs 270 in the pad regions GP, respectively. The gate electrodes 230 may have an increased thickness in the pad regions GP.

The gate electrodes 230 may include a metal material, such as tungsten (W). In example embodiments, the gate electrodes 230 may include polycrystalline silicon or metal silicide material. According to example embodiments, the gate electrodes 230 may further include a diffusion barrier 231. For example, the diffusion barrier 231 may include tungsten nitride (WN), tantalum nitride (TaN), titanium nitride (TiN), or a combination thereof.

The interlayer insulating layers 220 may be disposed between the gate electrodes 230 and may form the stack structures GS1 and GS2. Similarly to the gate electrodes 230, the interlayer insulating layers 220 may be spaced apart from each other in the vertical direction on lower surfaces of the first conductive layer 201 and the protective layer 251 and may extend in the X-direction. The interlayer insulating layers 220 may extend to the edge region EA, may be disposed between the sacrificial insulating layers 218 and may form the mold structures MS1 and MS2. The interlayer insulating layers 220 may include an insulating material such as silicon oxide or silicon nitride.

In example embodiments, thicknesses of the interlayer insulating layers 220 may not be the same. For example, among the interlayer insulating layers 220, the uppermost end interlayer insulating layer 223, the lowermost interlayer insulating layer 222 and the intermediate interlayer insulating layer 225 may have a thickness greater than that of the other interlayer insulating layers 220, but an example embodiment thereof is not limited. Thereto. The intermediate interlayer insulating layer 225 may be defined as the interlayer insulating layers between the stack structures GS1 and GS2.

The sacrificial insulating layers 218 may be spaced apart from each other in the vertical direction and may extend in the X-direction on a lower surface of the protective layer 251, similar to the gate electrodes 230 in the edge region EA. In the edge region EA, the sacrificial insulating layers 218 may be stacked alternately with the interlayer insulating layers 220, and may form the mold structures MS1 and MS2. The sacrificial insulating layers 218 may be material layers which may not be replaced with the gate electrodes 230 depending on a distance from the isolation regions MS when replacing the gate electrodes 230, and may include a material having etch selectivity with the interlayer insulating layers 220. For example, the interlayer insulating layer 220 may be formed of at least one of silicon oxide and silicon nitride, and the sacrificial insulating layers 218 may be formed of a material different from that of the interlayer insulating layer 220, selected from among silicon, silicon oxide, silicon carbide, and silicon nitride. Also, thicknesses of the interlayer insulating layers 220 and the sacrificial insulating layers 218 and the number of films included therein may be varied from the illustrated examples.

The isolation regions MS may be disposed to penetrate at least a portion of the gate electrodes 230 and may extend in the X-direction. The isolation regions MS may be disposed in parallel to each other. The isolation regions MS may penetrate the entire stacked gate electrodes 230 and may be connected to the lower insulating layer 291. The isolation regions MS may extend as an integrated region in the X-direction, or may extend intermittently in a portion or may be disposed only in a portion of a region.

An isolation insulating layer 264 may be disposed in the isolation regions MS. The isolation insulating layer 264 may have a shape of which a width increases toward the first substrate 101 due to a high aspect ratio thereof, but an example embodiment thereof is not limited thereto. A lower surface of the isolation insulating layer 264 may be in contact with the lower insulating layer 291, and an upper surface may be in contact with a lower surface of the first conductive layer 201. The isolation insulating layer 264 may not extend to the edge region EA, may be disposed only in the first extension region R2a and the second extension region R2b, and in the process of opening the isolation regions MS and replacing the sacrificial insulating layer 218 with the gate electrodes 230, the sacrificial insulating layers 218 in the edge region EA may remain without being replaced, such that the mold structures MS1 and MS2 may be maintained.

As illustrated in FIG. 3, the isolation regions MS may be formed to have a curved surface on a side surface, and may have a structure in which a curved surface having a convex curvature toward an external entity may be continuously formed. The curved surface structure of a side surface may be derived by forming the isolation regions MS by forming a plurality of isolation holes isolated from each other simultaneously when the channel hole is formed, and expanding the plurality of isolation holes to connect to each other through a cleaning process.

By forming the isolation regions MS from the isolation hole, a high aspect ratio etching process of forming other isolation regions MS may not be further performed, and may be performed simultaneously with a process of forming the channel hole, such that an all-in-one high aspect ratio contact (HARC) etching process may be performed.

The insulating regions SS may extend in the X-direction between the isolation regions MS adjacent to each other. The insulating regions SS may be disposed in a portion of the first extension region R2a and the second extension region R2b and in the first region R1. The insulating regions SS may penetrate the upper gate electrode 230U disposed on an uppermost end of the gate electrodes 230. The insulating regions SS may divide the upper gate electrode 230U in the Y-direction, as illustrated in FIG. 3. However, the number of the gate electrodes 130U isolated by the upper isolation regions SS may be varied in example embodiments.

The insulating regions SS may be disposed to cross a portion of the channel structures CH. The insulating regions SS may have a desired and/or alternatively predetermined width in the Y-direction and may extend to cross the plurality of channel structures CH arranged in a matrix in a zigzag pattern in the X-direction. Accordingly, when the plurality of channel structures CH are arranged to have the same spacing distance, the insulating regions SS may extend to cross a row of channel structures CH simultaneously. The insulating regions SS may be recessed into an upper end of the channel structures CH, for example, a portion of the channel structures CH opposing a gate electrode 130U, and accordingly, a portion of the channel structures CH may be removed. In this case, the channel structures CH may be recessed by a length smaller than a radius of the channel structures CH, and the radius may be from a channel central axis to an inner wall of the channel hole. Accordingly, the insulating regions SS may not pass through the channel central axis of the channel structure CH, and the channel structure CH may be disposed such that more than 1/2 of the channel structure CH may remain on an upper surface, but an example embodiment thereof is not limited thereto. The channel structures CH recessed by the insulating regions SS may be configured as effective channel structures which may not be dummy channel structures and may actually function as memory cells. In this case, the insulating region SS disposed at a center of each memory block BLK may be disposed by recessed into the entire channel structure CH, and the recessed channel structure CH may be a dummy channel structure DCH and may not function as an actual memory cell. Each of the insulating regions SS may include an upper isolation insulating layer 268. The upper isolation insulating layer 268 may include an insulating material, for example, silicon oxide, silicon nitride, or silicon oxynitride.

The channel structures CH may be spaced apart from each other in rows and columns on a lower surface of the first conductive layer 201 of the first region R1. The channel structures CH may be disposed in a zigzag pattern in one direction on the X-Y plan. The channel structures CH may penetrate the gate electrodes 230, may extend vertically to a lower surface of the first conductive layer 201, for example in the Z-direction, may have a pillar shape, and may have an inclined side surface having a width decreasing toward the first conductive layer 201 depending on an aspect ratio.

Each of the channel structures CH may have a shape in which the lower channel structure CH1 and the upper channel structure CH2 penetrating the lower stack structure GS1 and the upper stack structure GS2 of the gate electrodes 230, respectively, are connected to each other, and may have a bent portion due to a difference or a change in width in the connection region.

As illustrated in the enlarged diagram in FIG. 5A, each of the channel structures CH may include a first portion in the stack structures GS1 and GS2 and a second portion protruding to a region above the stack structures GS1 and GS2.

The channel layer 240 may be disposed entirely in the first and second portions of the channel structure CH, and may be disposed up to an upper end of the second portion. The component may be disposed in a second portion of the channel structure CH, and the channel layer 240 may include a protrusion portion 240a protruding and exposed to a region above the stack structures GS1 and GS2 and a non-protrusion portion 240b disposed in the first portion of the channel structure CH. In the channel structures CH, protruding lengths h1 of the second portions and the protrusion portions 240a of the channel layer 240 may not be the same, but an example embodiment thereof is not limited thereto. The channel layer 240 may be formed in an annular shape of which a side surface may surround the internal buried insulating layer 247, but in example embodiments, the channel layer 240 may also have a pillar shape such as a cylindrical shape or a prism shape without the buried insulating layer 247. The protrusion portion 240a of the channel layer 240 may be covered with the first conductive layer 201 and may be in direct contact with the first conductive layer 201. The protrusion portion 240a may be formed to have a gentle slope with the non-protrusion portion 240b to maintain the annular shape as illustrated in FIG. 5A. The channel layer 240 may include a semiconductor material such as polycrystalline silicon or single crystal silicon, and the semiconductor material may be an undoped material or a material including P-type or N-type impurities.

The channel pads 249 may be disposed on a lower portion of the channel layer 240 in the channel structures CH. The channel pads 249 may be disposed to cover a lower surface of the buried insulating layer 247 and may be electrically connected to the channel layer 240. The channel pads 249 may include, for example, doped polycrystalline silicon.

The data storage structure 245 may be disposed between the gate electrodes 230 and the channel layer 240. The data storage structure 245 may include a tunneling layer 241, a charge storage layer 242, and a blocking layer 243 stacked in order from the channel layer 240. The tunneling layer 241 may tunnel electric charges into the charge storage layer 242 and may include, for example, silicon oxide (SiO₂), silicon nitride (Si₃N₄), silicon oxynitride (SiON), or combinations thereof. The charge storage layer 242 may be configured as a charge trap layer or a floating gate conductive layer. The blocking layer 243 may include silicon oxide (SiO₂), silicon nitride (Si₃N₄), silicon oxynitride (SiON), a high-κ dielectric material, or a combination thereof. According to example embodiments, at least a portion of the data storage structure 245 may form a channel dielectric layer extending in the horizontal direction along the gate electrodes 230.

The data storage structure 245 may be removed from an upper portion of the stack structures GS1 and GS2 such that the protrusion portion 240a of the channel layer 240 may be exposed to an external entity in the second portion. Accordingly, an upper end of the data storage structure 245 may be in contact with the first conductive layer 201, and a side surface of the data storage structure 245 in the first portion may be disposed to surround the non-protrusion portion 240b of the channel layer 240.

The channel layer 240, the data storage structure 245, and the buried insulating layer 247 may be connected to each other between the upper channel structure CH2 and the lower channel structure CH1. As described above, the intermediate interlayer insulating layer 225 having a relatively great thickness may be disposed between the upper channel structure CH2 and the lower channel structure CH1.

The support structures 265 may be disposed in the first extension region R2a and the second extension region R2b, and may have a structure the same as or similar to that of the channel structures CH, and may not perform an actual function in the semiconductor device 10. The support structures 265 may be disposed regularly in columns and rows in the first extension region R2a and the second extension region R2b. The support structures 265 may have a diameter equal to or smaller than a maximum diameter of the contact plugs 270. The of the support structures 265, the number of the support structures 265 and/or a spacing therebetween may be varied. The channel structures CH and the support structures 265 may have a circular or a shape close to a circular shape, but an example embodiment thereof is not limited thereto, and the channel structures CH and the support structures 265 may have an oval shape. The support structures 265 may be configured as a supporter which may limit and/or prevent deformation such as bending of the stack structures GS1 and GS2.

The contact plugs 270 may be connected to contact regions of the gate electrodes 230 in the gate pad regions GP of the first extension region R2a and the second extension region R2b. The contact plugs 270 may penetrate at least a portion of the upper capping layer 290 and may be connected to each of the contact regions of the gate electrodes 230 exposed upwardly. The contact plugs 270 may penetrate the gate electrodes 230 below the contact regions and may be connected to the upper bonding structure 280 in the second semiconductor structure S2 and the lower bonding structure 180 in the first semiconductor structure S1. The contact plugs 270 may be spaced apart from the gate electrodes 230 below the contact regions by the contact insulating layers 260. However, in some example embodiments, the contact plugs 270 may be disposed to not penetrate the gate electrodes 230, and in this case, the contact plugs 270 may be connected to each of the contact regions of the gate electrodes 230 exposed upwardly.

The contact plugs 270 may have a shape corresponding to the channel structures CH, or a shape corresponding to the isolation region MS. Each of the contact plugs 270 may extend to an upper region and an upper region penetrating the stack structures GS1-GS2, respectively and may include a lower region below the upper region. Due to an aspect ratio, the lower region and the upper region may have an inclined side surface of which a width may decrease toward the protective layer 251 in each of the stack structures GS1 and GS2, and may have a cylindrical shape.

As illustrated in FIG. 4A, each of the contact plugs 270 may have a shape extending horizontally from the contact region. The contact plug 270 may include a vertical extension portion 270V extending in the Z-direction and a horizontal extension portion 270H extending horizontally from the vertical extension portion 270V and in contact with the gate electrode 230. The horizontal extension portion 270H may be disposed along a circumference of the vertical extension portion 270V, and an entire side surface thereof may be surrounded by the gate electrode 230. A length from a side surface of the vertical extension portion 270V to an end of the horizontal extension portion 270H may be smaller than a length from a side surface of the vertical extension portion 270V to external side surfaces of the contact insulating layers 260. The contact plugs 270 may be spaced apart from the gate electrodes 230 below the contact regions, that is, the gate electrodes 230, not electrically connected, by the contact insulating layers 260.

The contact plugs 270 may include at least one of a conductive material, for example, tungsten (W), copper (Cu), aluminum (Al), and alloys thereof. In some example embodiments, the contact plugs 270 may include a barrier layer extending along a side surface and a bottom surface, or may have an air gap therein.

The contact insulating layers 260 may be disposed to surround a side surface of each of the contact plugs 270 below the contact regions. The contact insulating layers 260 may be spaced apart from each other in the Z-direction around each of the contact plugs 270. The contact insulating layers 260 may be disposed on substantially the same level as a level of the gate electrodes 230. The contact insulating layers 260 may include an insulating material, for example, silicon oxide, silicon nitride, or silicon oxynitride.

The external contact vias 275 may be connected to transmit an external signal to the first semiconductor structure S1 through the pad region 258 and the upper interconnection structure 272 of the second semiconductor structure S2, which may be externally exposed, in the edge region EA. The external contact vias 275 may penetrate the mold structures MS1 and MS2 and may be connected through the pad region 258 and the upper studs 257 exposed upwardly. The external contact vias 275 may penetrate the mold structures MS1 and MS2 and may be connected to upper bonding structure 280 in the second semiconductor structure S2 and the lower bonding structure 180 in the first semiconductor structure S1.

The external contact vias 275 may have a shape corresponding to the channel structures CH, or a shape corresponding to the isolation region MS. Each of the external contact vias 275 may include a lower region penetrating the mold structures MS1 and MS2, and an upper region extending with the lower region and present below the lower region. Due to an aspect ratio, the lower region and the upper region may have an inclined side surface of which a width may decrease toward the protective layer 251 in each of the mold structures MS1 and MS2, and may have a cylindrical shape. An upper end width of the external contact vias 275 may be 1.5 to 3 times an upper end width of the channel structure CH, but an example embodiment thereof is not limited thereto. The external contact vias 275 may include at least one of a conductive material, for example, tungsten (W), copper (Cu), aluminum (Al), and alloys thereof.

The cell guide structure CD may be disposed in a boundary region between the first region R1, the first extension region R2a and the second extension region R2b and in a boundary region between the first region R1 and the edge region EA. The cell guide structure CD may be disposed such that lines having the same width may form a frame shape on the X-Y plane, and on the cross-section in the Z-direction, may have a shape in which a width W1 of a lower surface may be smaller than a width W2 of an upper surface on the lowermost interlayer insulating layer 222 in the Z-direction vertical to the first substrate 101, and may have a shape having a width increasing upwardly. A largest width W2 of an upper surface of the cell guide structure CD may be 500 to 1000 nm, or the largest width W2 may have be 800 to 1000 nm, but an example embodiment thereof is not limited thereto.

The cell guide structure CD may include a guide insulating layer 250, and the guide insulating layer 250 may include a cell guide structure region 250V extending in the Z-direction and an extension insulating layer region 250H extending from the cell guide structure region 250V to the protective layer 251. A thickness of the cell guide structure region 250V may be 300 nm to 500 nm, or 400 nm to 450 nm, but an example embodiment thereof is not limited thereto, and the extension insulating layer region 250H may have a thickness less than a thickness of the cell guide structure region 250V.

The cell guide structure CD may be defined as a structure including a portion of the cell guide structure region 250V and the extension insulating layer region 250H overlapping the cell guide structure region 250V in the z direction, and the extension insulating layer region 250H may extend from the cell guide structure CD to an upper surface of the protective layer 251.

A side surface of the cell guide structure CD may have an inclined surface, and angles of two inclined surfaces may be the same. An internal side surface of the cell guide structure CD may be in direct contact with the first conductive layer 201, and an external side surface may be in direct contact with the protective layer 251. A side surface of the cell guide structure CD may be a cell guide structure region 250V up to the same level as a level of the upper surface of the protective layer 251, an angle formed between an internal side surface and an upper surface of the external uppermost end interlayer insulating layer 222 may have a first angle Θ1, a width thereof may increase upwardly in the Z-direction, the extension insulating layer region 250H connected to the protective layer 251 may have a second angle Θ2 greater than the first angle Θ1, and the width may not extend. Accordingly, an internal side surface of the cell guide structure CD may have an inflection point at which a slope thereof may change between the extension insulating layer region 250H and the cell guide structure region 250V.

The first conductive layer 201 and the second conductive layer 202 may be disposed on an internal portion of a frame formed by the cell guide structure CD, that is, on the first region R1.

The first conductive layer 201 may be disposed between a lower surface of the second conductive layer 202 and the stack structures GS1 and GS2 in the first region R1. The first conductive layer 201 may include a semiconductor material. For example, the first conductive layer 201 may include a semiconductor material, such as a group IV semiconductor, a group III-V compound semiconductor, or a group II-VI compound semiconductor. For example, a group IV semiconductor may include silicon (Si), germanium (Ge), or silicon-germanium (SiGe). The first conductive layer 201 may function as a common source line CSL of the semiconductor device 10. The first conductive layer 201 may include a silicon layer, for example, a silicon layer having an N-type conductivity. For example, the first conductive layer 201 may be provided as a crystalline semiconductor layer such as a single-crystalline silicon layer and a polycrystalline silicon layer doped with impurities, and an epitaxial layer. As illustrated in the enlarged diagram in FIG. 5A, the first conductive layer 201 may cover a second portion of the channel structure CH, and may be in direct contact with the protrusion portion 240a of the channel layer 240.

The first conductive layer 201 disposed in a frame of a cell guide structure CD may be configured as a plate layer entirely covering the frame, and may be disposed such that an upper surface may be configured to be flat. In the frame, the first conductive layer 201 may be disposed to have a first thickness h2, and the first thickness h2 may be greater than a length h1 of the protrusion portion 240a of the channel layer 240. For example, when the length h1 of the protrusion portion 240a of the channel layer 240 satisfies 150nm to 180nm, the first thickness h2 of the first conductive layer 201 may satisfy 200nm to 220nm, which may be greater than the length h1 of the protrusion portion 240a, and the first conductive layer 201 may remain as much as a second thickness h3 above the protrusion portion 240a.

In the frame, an upper surface of the first conductive layer 201 may be disposed on a level lower than a level of an upper surface of the cell guide structure CD, and a lower surface of the first conductive layer 201 may be disposed on a level lower than a level of a lower surface of the cell guide structure CD. A lower surface of the first conductive layer 201 may be disposed in the frame to be recessed by a desired and/or alternatively predetermined length h5 than the lower surface of the cell guide structure CD. Accordingly, in the frame, the first conductive layer 201 may be disposed to be recessed concavely and downwardly from the cell guide structure CD.

The first conductive layer 201 may have an inclined surface on a side surface in contact with the cell guide structure CD. Each inclined surface of the first conductive layer 201 may be in contact with an inclined surface of the cell guide structure CD, and may have a first angle Θ1, an acute angle with respect to an upper surface of the interlayer insulating layer 222, that is, a lower surface of the first conductive layer 201, as illustrated in FIG. 5B. Accordingly, a width of the first conductive layer 201 in the frame may decrease upwardly in the Z-direction, and may form an inclined surface on a side surface, and an area of the upper surface of the first conductive layer 201 in the frame may be smaller than an area of the lower surface.

The second conductive layer 202 may be disposed along the first conductive layer 201. The second conductive layer 202 may have a thickness smaller than that of the first conductive layer 201 and may be configured as a conductive layer in contact with the first conductive layer 201. The second conductive layer 202 may include at least one of a metal-semiconductor compound, metal-nitride, and metal (e.g., tungsten (W), copper (Cu), aluminum (Al)). The second conductive layer 202 may be vertically aligned with the first conductive layer 201. The second conductive layer 202 may include at least three layers as illustrated in FIG. 5B and may have a stack structure including an ohmic contact layer 202b, a conductive metal layer 202a, and a diffusion barrier 202c therebelow.

When the lower first conductive layer 201 includes a semiconductor layer, the ohmic contact layer 202b may be configured as a resistive layer to form ohmic contact with the conductive metal layer 202a, and when the conductive metal layer 202a is formed of a conductive metal such as tungsten (W), the ohmic contact layer 202b may be, for example, titanium (Ti) or tantalum (Ta). The diffusion barrier 202c may be disposed on the conductive metal layer 202a and may be configured to limit and/or prevent diffusion of the conductive metal layer 202a into the buffer layer 205 and may include a nitride film, for example, titanium nitride film (TiN), tantalum nitride film (TaN), tungsten nitride film (WN), but an example embodiment thereof is not limited thereto. In the second conductive layer 202, a thickness of the conductive metal layer 202a may be the largest, thickness of the ohmic contact layer 202b and the diffusion barrier 202c may be relatively small, and a thickness of the conductive metal layer 202a may account for more than 60% of the entirety, but an example embodiment thereof is not limited thereto.

In the frame, the first and second conductive layers 201 and 202 may be configured as source layers, and may form a source structure together. The source structure may function as a common source line CSL for the semiconductor device 10.

A buffer layer 205 may be further formed on the second conductive layer 202. The buffer layer 205 may protect the first and second conductive layers 201 and 202 when the second conductive layer 202 and the first conductive layer 201 are patterned. The buffer layer 205 may be an oxide conformally covering the second conductive layer 202, and may include silicon oxide or silicon nitride.

In first region R1, the first conductive layer 201, the second conductive layer 202 and the buffer layer 205 may have the same area. The first conductive layer 201, the second conductive layer 202 and the buffer layer 205 may include an extension region CSL_{E} covering an inclined surface of an internal side surface of the cell guide structure CD from an internal potion of the frame and extending to an upper surface of the cell guide structure CD. The extension region CSL_{E} of the common source line CSL may not extend externally of the cell guide structure CD, and may be limited to an upper surface of the cell guide structure CD. The first conductive layer 201 of the extension region CSL_{E} disposed on a side surface and an upper surface of the cell guide structure CD may have a second thickness h4 different from the first thickness h2, and the second thickness h4 may be smaller than the first thickness h2. As an example, the second thickness h4 may be 40 nm to 60 nm, or 50 nm to 60 nm, but an example embodiment thereof is not limited thereto. A thickness of the second conductive layer 202 in the extension region CSL_{E} may have a range similar to that of the thickness of the second conductive layer 202 in the frame.

Meanwhile, a protective layer 251 may be disposed on the first extension region R2a, the second extension region R2b and the edge region EA externally of the cell guide structure CD. The protective layer 251 may be configured an absorption layer for absorbing energy and heat to limit and/or prevent metal migration of the interconnection structures 271, 272, and 284 therebelow during laser annealing of the first conductive layer 201, and may include a material having relatively low thermal conductivity. As an example, a nitride film, specifically SiN, especially a stress-enhanced nitride film specialized for passivation, such as plasma enhanced SiN (PE-SiN), may be disposed. The protective layer 251 may be in direct contact with an external side surface of the cell guide structure CD on a side surface, and a thickness of the protective layer 251 may be greater than a first thickness h2 of the first conductive layer 201, but an upper surface may be disposed on a level lower than a level of an upper surface of the cell guide structure CD. The extension guide region 250H of the cell guide structure CD may extend to cover an upper surface of the protective layer 251.

When the gate electrodes 230 are gradually removed and form a staircase shape, or when only the mold structures MS1 and MS2 are formed, energy may be substantially transmitted to the interconnection structures 171, 172, and 174 relatively further below the memory cell region R1. By disposing the protective layer 251 on the first extension region R2a, the second extension region R2b and the edge region EA, the energy transmission downwardly while the MLA process is performed on the first conductive layer 201 may be limited and/or prevented. Accordingly, defects caused by diffusion of a metal, such as copper, forming the interconnection structures 171, 172, and 174 therebelow may be addressed.

Also, after the protective layer 251 is entirely formed, the cell guide structure CD may be formed to define the memory cell region R1 and the other regions R2a, R2b, and EA, and only the protective layer 251 of the first region R1 may be selectively removed, thereby forming the common source line CSL. By forming a guide structure on a base substrate before forming the channel structure CH by performing the processes in sequence as above, when the gate electrode 230 is replaced through the isolation region MS in the guide structure intersecting the isolation region MS, defects occurring due to a metal material remaining in a portion of the guide structure may be limited and/or prevented.

When the protective layer 251 is applied as a nitride film, specifically SiN, especially PE-SiN (plasma enhanced SiN), H-rich SiN may be applied. In other words, by applying a nitride film having a high hydrogen content, a hydrogen path may be formed during a subsequent heat treatment to activate the channel layer 240.

The upper insulating structure 210 may be disposed to cover both the common source line CSL and the protective layer 251.

The upper insulating structure 210 may include a first insulating layer 211, a second insulating layer 212 and a hydrogen supply layer 213. The first insulating layer 211 may cover the buffer layer 205 and the extension region CSL_{E}, and an upper surface thereof may be formed to be flat and may include an insulating material, for example, silicon oxide, silicon nitride, or silicon oxynitride. The second insulating layer 212 may include silicon oxide, silicon nitride, or silicon oxynitride similarly to the first insulating layer 211, and may be formed to have a thickness smaller than that of the first insulating layer 211. The hydrogen supply layer 213 may be H-rich SiN and may be formed of a material such as PE-SiN, and annealing may be performed while up to the hydrogen supply layer 213 is formed, thereby forming a hydrogen path to the channel layer 240. To this end, the first insulating layer 211 may include TEOS and the second insulating layer 212 may include HDP oxide, but an example embodiment thereof is not limited thereto.

The second semiconductor structure S2 may further include a source contact via 255 on the second conductive layer 202 and a source interconnection 256 on the source contact via 255, and the source contact via 255 may penetrate the buffer layer 205 and first insulating layer 211 such that the source interconnection 256 on the second conductive layer 202 may be disposed on the first insulating layer 211, or may be disposed on the second insulating layer 212.

Also, the upper studs 257 connecting the external contact vias 275 to the pad region 258 in the edge region EA may be disposed, and the pad region 258 may be disposed on the first insulating layer 211. The upper studs 257 may be disposed in a multilayer structure, and when the upper studs 257 are disposed in multiple layers, an interconnection structure may be further disposed therebetween, but an example embodiment thereof is not limited thereto. The second insulating layer 212 and the hydrogen supply layer 213 may be disposed to cover edges of the pad region 258, and a central region of the pad region 258 may be exposed and may be provided to be connected to a wire.

The passivation layer 215 may be disposed on an upper surface of the hydrogen supply layer 213. The passivation layer 215 may function as a layer protecting the semiconductor device 10. In an example embodiment, the passivation layer 215 may have an opening (OI) in a portion of a region, and accordingly, the pad region 258 connected to an external entity may be defined. The passivation layer 215 may include an organic material, or alternatively, the passivation layer 215 may include at least one of silicon oxide and silicon carbide, and may function as a capping layer.

The upper interconnection structures 271 and 272 may electrically connect the gate electrodes 230 and the channel structures CH to the circuit devices 120. The upper interconnection structures 271 and 272 may include studs 272 connected to the channel structures CH, studs 272 connected to the contact plug 270, and studs 272 connected to the external contact vias 275. The studs 272 connected to the channel structure CH may be connected to the channel pad 249 of the channel structure CH. The studs 272 connected to the channel structures CH may be electrically connected to the channel layer 240 through the channel pad 249 of the channel structures CH in the first region R1. In the first extension region R2a and the second extension region R2b, the studs 272 may be connected to the contact plugs 270 connected to the gate electrode 230. The upper interconnection line 271 may be connected to the studs 272. The upper interconnection structures 271 and 272 may include a conductive material, for example, tungsten (W), copper (Cu), and aluminum (Al), and each component may further include a diffusion barrier including at least one of titanium (Ti), titanium nitride (TiN), tantalum (Ta), tantalum nitride (TaN), and tungsten nitride (WN). According to example embodiments, the number of layers of the studs 272 and the upper interconnection lines 271 included in the upper interconnection structures 271 and 272 and the dispositional form thereof may be varied, and high energy and heat may be blocked by the protective layer 251 disposed in an upper portion such that diffusion of metal material in the upper interconnection structures 271 and 272 may not occur, and device reliability may be improved.

The upper bonding structure 280 may be connected to the upper interconnection structures 271 and 272. For example, the studs 272 may be electrically connected to the upper bonding structure 280. The upper bonding structure 280 may include an upper bonding via 282, an upper bonding pad 284, and an upper bonding insulating layer 286. The upper bonding via 282 may be connected to the upper interconnection structure 270. The upper bonding pad 284 may be connected to the upper bonding via 282. The upper bonding via 282 and the upper bonding pad 284 may include a conductive material, for example, tungsten (W), copper (Cu), aluminum (Al), and each component may further include a diffusion barrier. The upper bonding insulating layer 286 may also function as a diffusion barrier of the upper bonding pad 284 and may include at least one of SiCN, SiO, SiN, SiOC, SiON and SiOCN. The upper bonding insulating layer 286 may have a thickness less than a thickness of the upper bonding pad 284, but an example embodiment thereof is not limited thereto.

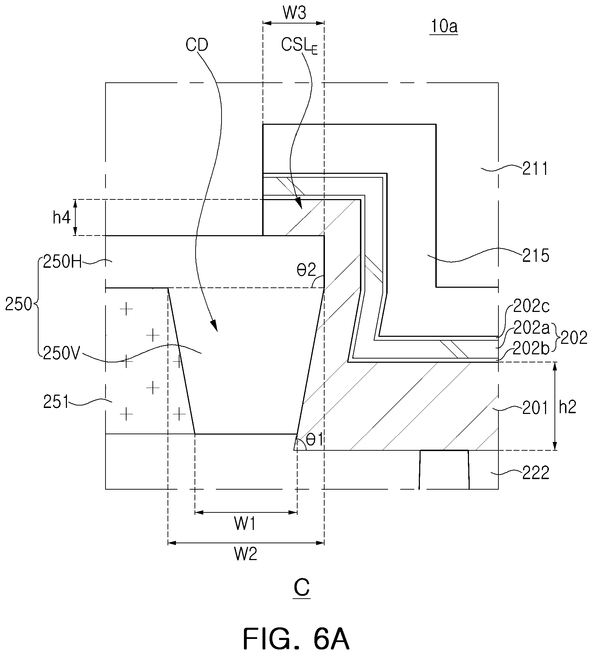

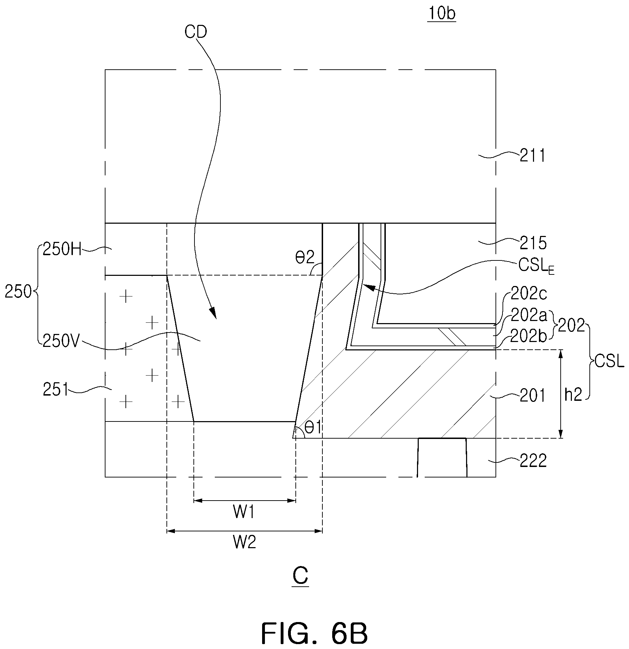

Hereinafter, example embodiments will be described with reference to FIGS. 6A to 12. FIGS. 6A and 6B are enlarged views illustrating semiconductor devices according to example embodiments, illustrating region "C" in FIG. 4B.

Referring to FIG. 6A, the semiconductor device 10a may be the same as the example in FIG. 5B other than the configuration in which the extension region CSL_{E} of the common source line CSL has a width W3 smaller than a width W2 of the upper surface on an upper surface of the cell guide structure CD.

Specifically, in the semiconductor device 10a, a common source line CSL may be disposed in a cell guide structure CD defining a first region R1 in which channel structures CH are disposed. As described above, the common source line CSL may have a stack structure of a first conductive layer 201 and a second conductive layer 202. When the common source line CSL is disposed in a frame formed by the cell guide structure CD, the first conductive layer 201 and the second conductive layer 202 may extend along an internal side surface of the cell guide structure CD and may include an extension region CSL_{E} extending to a region above an upper surface of the cell guide structure CD. The extension region CSL_{E} may be bent and may extend from an internal side surface of the cell guide structure CD to have a width W3 smaller than the width W2 of the upper surface of the cell guide structure CD. Accordingly, a side end of the extension region CSL_{E} may be exposed on the upper surface of the cell guide structure CD.

Referring to FIG. 6B, a semiconductor device 10b may be the same as the example in FIG. 5B other than the configuration in which an extension region CSL_{E} of a common source line CSL is not bent to a region above an upper surface of a cell guide structure CD.

Specifically, in the semiconductor device 10b, the common source line CSL may be disposed in the cell guide structure CD defining the first region R1 in which channel structures CH are disposed. As described above, the common source line CSL may have a stack structure of a first conductive layer 201 and a second conductive layer 202. When the common source line CSL is disposed in a frame formed by the cell guide structure CD, the first conductive layer 201 and the second conductive layer 202 may include an extension region CSL_{E} extending along an internal side wall of the cell guide structure CD. The first conductive layer 201 and the second conductive layer 202 forming the extension region CSL_{E} may not be bent to the upper surface of the cell guide structure CD, and may have an upper end coplanar with the upper surface of the cell guide structure CD. The buffer layer 205 may be formed to fill the frame on an upper surface and a side surface of the second conductive layer 202, and an upper surface of the buffer layer 205 may also be coplanar with an upper surface of the cell guide structure CD. As the upper surface of the cell guide structure CD, an upper end of the common source line CSL and buffer layer 205 are planarized to be coplanar with each other as described above, the thickness of the layered structures on the channel structure CH may be reduced, thereby reducing a size thereof.

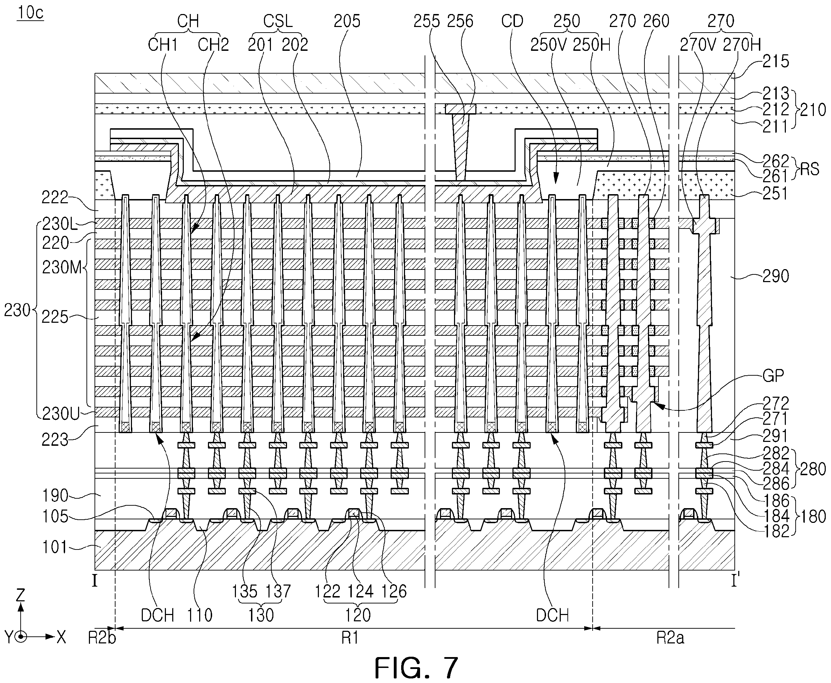

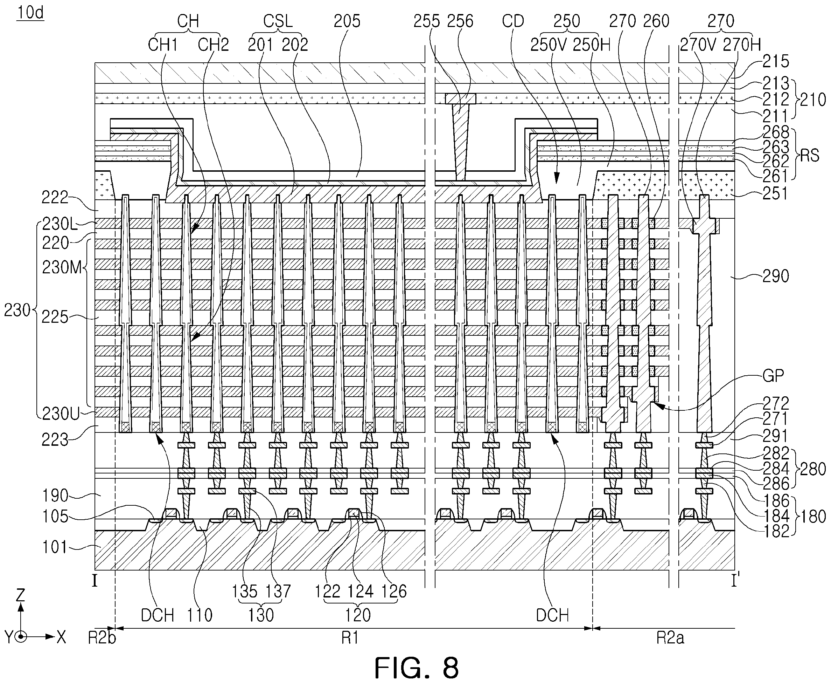

FIGS. 7 and 8 are cross-sectional views illustrating semiconductor devices according to example embodiments, illustrating the same region as in FIG. 4A.

Referring to FIG. 7, a semiconductor device 10c may be the same as the example in FIG. 4A other than the configuration in which a reflective structure RS is disposed in a region other than a first region R1, and dummy channel structures DCH are disposed below a cell guide structure CD.

Specifically, a semiconductor device 10c may further include the reflective structure RS on an extension guide region 250H of a cell guide structure CD defining the first region R1 in which channel structures CH are disposed. The reflective structure RS may be disposed on first and second extension regions R2a and R2b and an edge region EA, and may be disposed on the cell guide structure CD, which is a portion of the first region R1. Accordingly, an area of the reflective structure RS may be smaller than the area of the protective layer 251.

The reflective structure RS may include a stack structure of the first material layer 261 and the second material layer 262, and the first material layer 261 and the second material layer 262 may extend by being in contact with an upper surface of extension guide region 250H on the extension guide region 250H of the cell guide structure CD. Accordingly, the reflective structure RS may extend to the edge region EA, may cover the entirety of the lower protective layer 251, and may have an area larger than the area in which the protective layer 251 is disposed.

The first material layer 261 and the second material layer 262 may be different material layers, and the first material layer 261 may include an oxide film, such as a silicon oxide film. The second material layer 262 may include a nitride film, such as a silicon nitride film, such as one of SiN, SiON, SiCN, and SiOCN. A thickness of the first material layer 261 and the second material layer 262 may be the same, but an example embodiment thereof is not limited thereto. The reflective structure RS may have a structure in which the second material layer 262 of a nitride film is stacked on the first material layer 261, and may absorb or reflect energy and heat incident from an external entity and may not transmit energy and heat downwardly. In other words, the reflective structure RS may perform a function similar to that of the lower protective layer 251, but when an oxide film and a nitride film are alternatively stacked in similar thickness ranges, performance of absorption and reflection of energy and heat may be improved. The extension region CSL_{E} of the common source line CSL may be bent to the reflective structure RS, and may be partially disposed, but an example embodiment thereof is not limited thereto.

The reflective structure RS may not extend to a frame of the cell guide structure CD, and may extend externally of an upper surface of the cell guide structure CD, such that energy transfer to the lower interconnection structures 271 and 272 disposed in the extension regions R2a and R2b and the edge region EA may be effectively blocked.

In the semiconductor device 10c in FIG. 7, dummy channel structures DCH may be further disposed below the cell guide structure CD. When a width of the cell guide structure CD is relatively larger than a width of the channel structure CH, and there is no vertical structure below the cell guide structure CD, dishing may occur and reliability may be reduced. By disposing the dummy channel structures DCH in a region below the cell guide structure CD, the component may function as a vertical structure. The configuration of the dummy channel structures DCH may be the same as the channel structures CH, and may not be connected to the interconnection structures 271 and 272. Also, the data storage structure 245 of the second portion of the dummy channel structure DCH protruding to the stack structures GS1 and GS2 may not be removed and may remain as is, and may cover the channel layer 240. The number of the dummy channel structures DCH may be determined depending on a width of the cell guide structure CD.

Referring to FIG. 8, a semiconductor device 10d may be the same as the example in FIG. 7 other than the shape of a multilayer structure of the reflective structure RS in regions other than a first region R1.

Specifically, a reflective structure RS may be disposed on the guide insulating layer 250 in the semiconductor device 10d. The reflective structure RS may be disposed on the first and second extension regions R2a and R2b and the edge region EA, and may be disposed on the cell guide structure CD, a portion of the first region R1. Accordingly, an area of the reflective structure RS may be smaller than an area of the protective layer 251.

In the reflective structure RS, a plurality of stack pairs of the first material layer 261 and the second material layer 262 may be disposed. For example, two pairs of the first material layers 261 and 263 and stack pairs of the second material layers 262 and 268 may be disposed. Alternatively, three to four stack pairs may be disposed. The plurality of first material layers 261, 263 and the plurality of second material layers 262, 268 may have a stack structure in which the plurality of first material layers 261, 263 and the plurality of second material layers 262, 268 may have a similar range of thickness and may be alternately stacked, and when the components are disposed to extend up to the edge region EA, energy absorption and reflection efficiency may be further improved, such that the amount of energy transmitted to the lower interconnection structures 271 and 272 may be significantly reduced. The reflective structure RS may not extend to a frame of the cell guide structure CD, and may extend externally of an upper surface of the cell guide structure CD, such that energy transfer to the lower interconnection structures 271 and 272 disposed in the extension region R2a and R2b and the edge region EA may be effectively blocked.

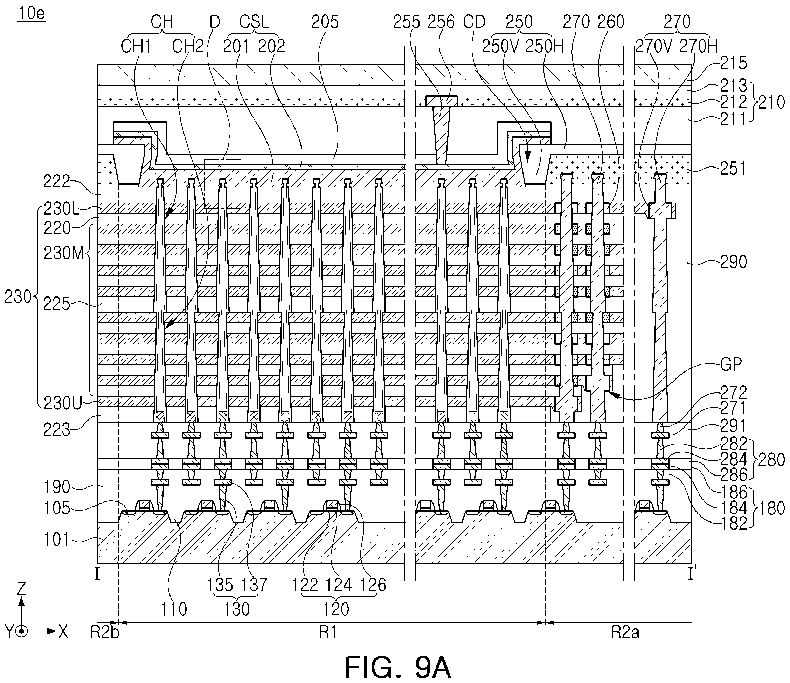

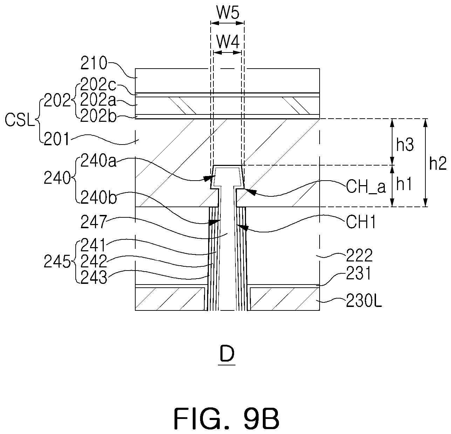

FIG. 9A is a cross-sectional view illustrating a semiconductor device according to an example embodiment, and FIG. 9B is an enlarged cross-sectional view illustrating region "D" in FIG. 9A.

Referring to FIGS. 9A and 9B, a semiconductor device 10E in the example embodiment may be the same as the example in FIG. 4A other than the configuration in which a shape of a protrusion portion 240a of each channel structure CH may include a head CH_a as illustrated in FIG. 9B.

Specifically, the channel structure CH may further include the head CH_a having an extended width at one end.

In the example embodiment illustrated in FIG. 9B, the head CH_a of the channel structure CH may have a width W5 larger than a width of the protrusion portion 240a of the channel layer 240. The head CH_a of the channel structure CH may be formed by a stopper for maintaining a depth of a channel hole uniformly during the manufacturing process, but an example embodiment thereof is not limited thereto.

The head CH_a may have different widths in the Z-direction, and for example, the head CH_a may have a width decreasing upwardly, but an example embodiment thereof is not limited thereto, and a width of an upper portion of the head CH_a W4 and a width W5 of a lower portion may be configured to be the same. In this case, the width W5 of the lower portion of the largest head CH_a may be configured to be larger than a width of the non-protrusion portion 240b of the channel layer 240.

In this case, the width W5 of the head CH_a may satisfy about 1/2 to 3/5 with respect to a spacing distance between the channel structure CH and the neighboring channel structure CH.

Even when the head CH_a is formed, a stack structure of a first portion of the channel structures CH may be formed the same as in FIG. 5A, a height of the protrusion portion 240a may be equal to a first height h1, and the head CH_a may be formed to have a length smaller than the length h1 of the protrusion portion 240a. The protrusion portion 240a of the channel layer 240 may be disposed on an outermost surface of the head CH_a, and an internal portion thereof may be filled with a buried insulating layer 247 or may be entirely filled with the channel layer 240 in example embodiments.

When head CH_a is formed in the protrusion portion 240a, a contact area between the first conductive layer 201 and the channel layer 240 may be expanded by the expanded one end, thereby increasing the amount of charge inflow.

In the example embodiment illustrated in FIG. 9B, in addition to the channel structure CH, contact plugs 270, which may be other vertical structures, may also include a head. The head of the contact plugs may also be formed by a stopper to maintain a depth of the contact hole uniformly during the manufacturing process, but an example embodiment thereof is not limited thereto. Also, the other vertical structures such as an isolation region MS, a supporter structure 265, an external contact via 275 and dummy channel structures DCH may also have a shape including a head by applying a stopper to ensure a uniform hole depth when forming a hole by HARC etching, but an example embodiment thereof is not limited thereto.

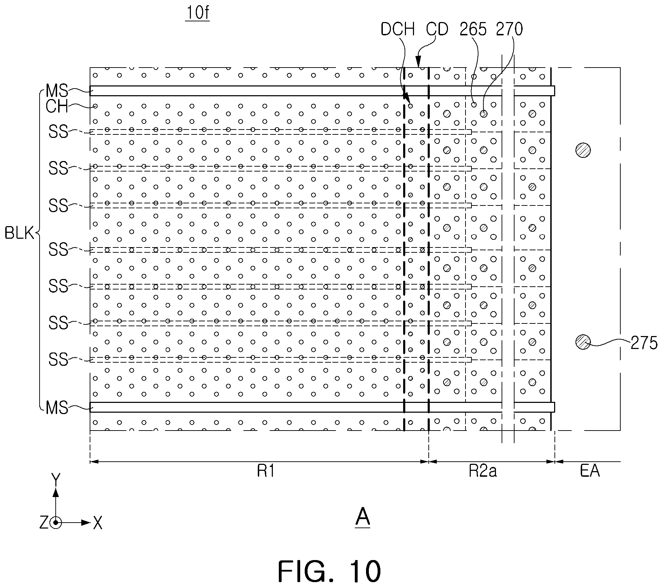

FIG. 10 is a plan view illustrating a semiconductor device according to example embodiments.

The semiconductor device 10f in FIG. 10 may be the same as the example in FIGS. 3 and 4A other than the configuration in which an isolation region MS has a flat side surface and a dummy channel structure DCH is disposed below the cell guide structure CD.

Specifically, in the semiconductor device 10f, a plurality of isolation regions MS crossing extension regions R2a and R2b from a first region R1 in the X-direction may be disposed, and each of the isolation regions MS may extend in the Z-direction from a second semiconductor structure S2 and may simultaneously penetrate a plurality of gate electrodes 230. Differently from FIGS. 3 and 4A and 4B, a continuous isolation hole such as a channel hole may be formed, an extension process to connect the holes may not be performed, and a sacrificial isolation region penetrating the plurality of mold structures MS1 and MS2 may be formed by performing collective etching using a separate etching process. Accordingly, a shape of the isolation region MS may have a flat side surface rather than a curved side surface.

In the semiconductor device 10f, as illustrated in FIGS. 7, 8, and 10, dummy channel structures DCH may be disposed in a lower portion of the cell guide structure CD. An interlayer structure of the dummy channel structures DCH may be the same as the channel structure CH, but the data storage structure 245 may surround the channel layer 240 entirely without exposing the protrusion portion 240a for being in direct contact with the common source line CSL. Also, the dummy channel structures DCH may not be connected to interconnections 271 and 272 and may not function as actual memory cells.

Five to ten dummy channel structures DCH may be disposed in a lower portion of the cell guide structure CD extending in the X-direction, and 10 to 15 dummy channel structures DCH may be spaced apart from each other in a lower portion of the cell guide structure CD extending in the Y-direction. The dummy channel structures DCH may be vertical structures and may support mold structures MS1 and MS2 or stack structures GS1 and GS2 to limit and/or prevent dishing.

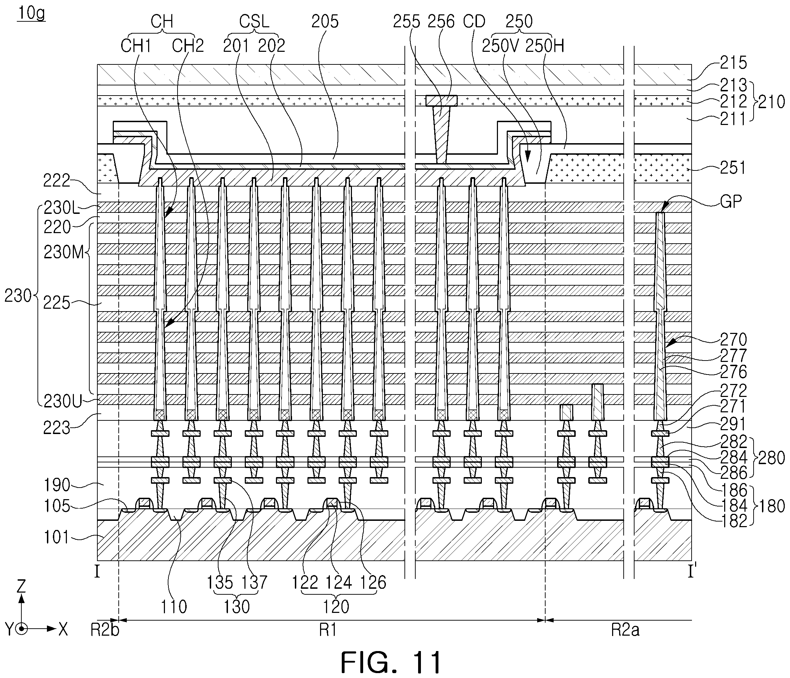

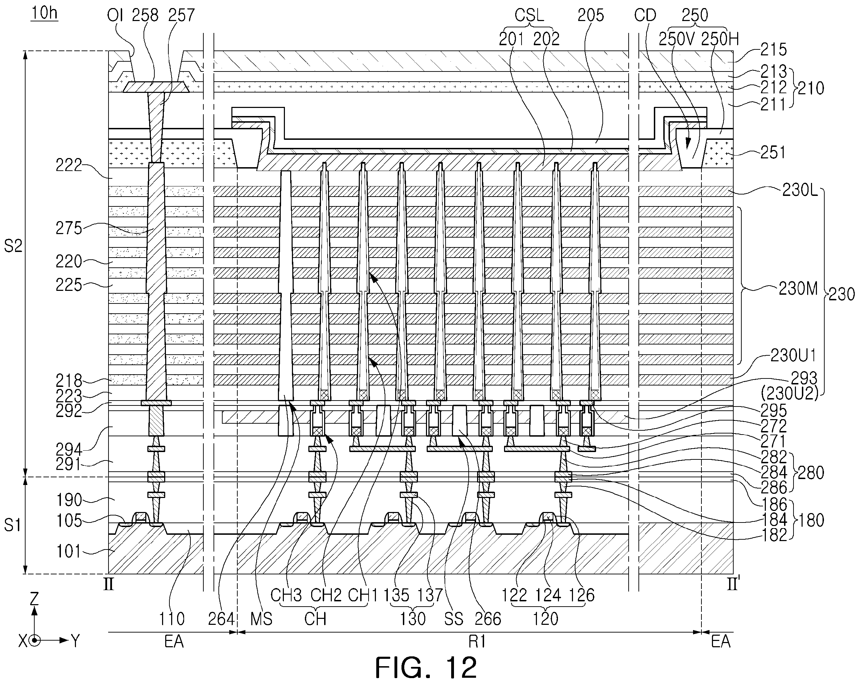

FIGS. 11 and 12 are cross-sectional views illustrating a semiconductor device according to example embodiments.

A semiconductor device 10g in FIG. 11 may be the same as the example in FIGS. 2 to 5B other than the configuration in which a shape of stack structures GS1 and GS2 in extension regions R2a and R2b and a shape of the contact plugs 270 connected to the gate electrodes 230, respectively, in the extension regions R2a and R2b may be different.

Specifically, the semiconductor device 10g in FIG. 11 may not include a staircase structure in which the gate electrodes 230 of a stack structure may be gradually etched in the extension regions R2a and R2b and exposing the gate pad region GP. That is, even in the extension regions R2a and R2b, the gate electrodes 230 of the stack structure may extend to the same length, such that the same length may be maintained from the first region R1 to the extension regions R2a and R2b. In this case, the contact plug 270, selectively connected to the gate electrode 230 and applying a signal, may extend to different levels in the Z-direction and may be in contact with different gate electrodes 230.

The contact plug 270 connected to an uppermost end gate electrode 230U may extend in the Z-direction until the contact plug 270 is in contact with a lower surface (an upper surface in the process) of the uppermost end gate electrode 230U, and may extend to a depth penetrating the uppermost end interlayer insulating layer 223.

When the contact plug 270 connected to the gate electrode 230 of the subsequent end of an uppermost end may extend from the uppermost end interlayer insulating layer 223 until the uppermost end interlayer insulating layer 223 is in contact with a lower surface (an upper surface in the process) of the gate electrodes 230 of the subsequent end of the uppermost end, such that the uppermost end interlayer insulating layer 223 may have a length longer than that of the contact plug 270 of the prior end. The contact plugs 270 may extend to penetrate the gate electrodes 230 and the interlayer insulating layers 220 of the upper gate electrodes 230 to be in direct contact with the lower surface (the upper surface in the process) of the gate electrodes 230 of each end.

Each contact plug 270 may include a conductive contact layer 276 extending from the uppermost end interlayer insulating layer 223 to the lower surface (the upper surface in the process) of the target gate electrodes 230, and a plug insulating layer 277 surrounding the conductive contact layer 276.

The plug insulating layer 277 may be formed on a side surface of the contact hole forming each contact plug 270, and the conductive contact layer 276 may be disposed to fill the contact hole in the plug insulating layer 277. In this case, the plug insulating layer 277 may be removed from a lower surface of each contact hole, that is, the region in contact with a lower surface (an upper surface in the process) of the corresponding gate electrodes 230, and the conductive contact layer 276 may be in direct contact with a lower surface (an upper surface in the process) of the target gate electrodes 230 while being exposed on the lower surface of each contact hole. As each contact plug 270 is in direct contact with the target gate electrodes 230 while the insulating layer 277 is present on the side surface, a staircase etching for the pad region GP of the plurality of gate electrodes 230 may not be provided, such that the process may be simplified.

The semiconductor device 10H in FIG. 12 may be the same as the example in FIGS. 3 to 5B other than the configuration in which the upper channel structure CH3 is disposed on the first and second channel structures CH1 and CH2 and may form one channel structure CH.

The upper channel structures CH3 may extend in the Z-direction by penetrating the upper gate electrode 293 (230U2), and may be connected to channel structures CH1 and CH2, respectively. The upper channel structures CH3 may be disposed on the channel structures CH1 and CH2, respectively, and may be offset from channel structures CH1 and CH2, but an example embodiment thereof is not limited thereto.

As illustrated in FIG. 12, each of the upper channel structures CH3 may include an upper channel layer, an upper gate dielectric layer, an upper channel buried insulating layer, and an upper channel pad disposed in an upper channel hole. The upper channel layer may be formed in an annular shape surrounding the upper channel buried insulating layer disposed therein. The upper channel layer may be connected to the connection pad 295 in a lower portion, and may be electrically connected to the channel layer 240 of the lower channel structures CH1 and CH2 through the connection pad 295.

The description of each of the above-mentioned lower channel layer 240, the data storage structure 245, the channel buried insulating layer 247, and the channel pad layer 249 may be applied to the description of materials of the upper channel layer, the upper gate dielectric layer, the upper channel buried insulating layer, and the upper channel pad.

The horizontal insulating layer 292 may be disposed between the lower channel structures CH1 and CH2 and the upper channel structures CH3 and may extend horizontally. The horizontal insulating layer 292 may be disposed between the upper gate electrode 130U2 and the uppermost end interlayer insulating layer 223. The horizontal insulating layer 292 may be used as an etch stop layer when the upper channel structures CH3 is formed, and may also be used when the connection pads 295 is formed.

The horizontal insulating layer 292 may include an insulating material and may include a material different from the interlayer insulating layer 223. The horizontal insulating layer 292 may be configured as a hydrogen blocking layer and may include a material preventing or reducing diffusion of hydrogen (H). The horizontal insulating layer 292 may include nitride, for example, at least one of SiN, SiON, SiCN, and SiOCN.

The connection pads 295 may penetrate the horizontal insulating layer 292 between the lower channel structures CH1 and CH2 and the upper channel structures CH3, and may electrically connect the lower channel layers 240 to the upper channel layers. The connection pads 295 may be formed by partially removing the horizontal insulating layer 292 and may have upper surfaces coplanar with an upper surface of the horizontal insulating layer 292. The connection pads 295 may be disposed in a shape in which the connection pads 295 is partially recessed into the lower channel pad layer. However, the specific dispositional form of the connection pads 295 may be varied in example embodiments. The connection pads 295 may include a conductive material, for example, polycrystalline silicon.

The upper insulating regions SS may extend in the X-direction between isolation regions MS adjacent to each other. The upper insulating regions SS may penetrate the upper gate electrode 293 (230U2) disposed in an uppermost portion of the gate electrodes 230. The upper insulating regions SS may divide the upper gate electrode 293 (230U2) in the Y-direction. A portion of the upper insulating regions SS may be disposed on the isolation regions MS.

Accordingly, the upper insulating regions SS may be separate only the upper gate electrode 293 (230U2), rather than being recessed into a portion of the channel structures CH as illustrated in FIG. 4B.

Each of the upper insulating regions SS may include an upper isolation insulating layer 266. The upper isolation insulating layer 266 may include an insulating material, for example, silicon oxide, silicon nitride, or silicon oxynitride.

The second horizontal insulating layer 294 may be disposed to cover the upper gate electrode 293 (230U2). The second horizontal region insulating layer 294 may be disposed on the horizontal insulating layer 292 and may cover a side surface of the upper gate electrode 293 (230U2). The lower insulating layer 291 may be disposed on the second horizontal region insulating layer 294, and the lower insulating layer 291 and the second horizontal region insulating layer 294 may be formed of an insulating material and may include a plurality of insulating layers.

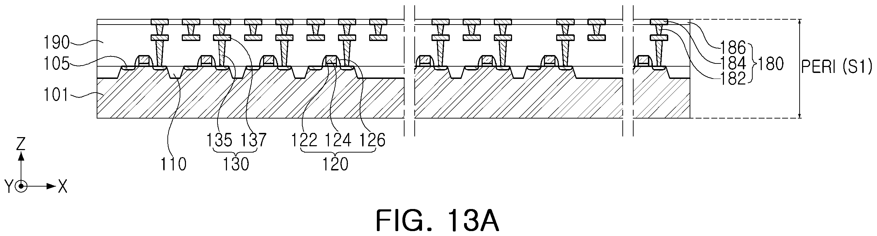

FIGS. 13A to 13O are cross-sectional diagrams illustrating a method of manufacturing a semiconductor device according to example embodiments, illustrating a region corresponding to FIG. 4A.

Referring to FIG. 13A, a first semiconductor structure S1 (PERI) including circuit devices 120, a lower interconnection structure 130, a lower bonding structure 180, and a lower capping layer 190 forming a peripheral circuit region PERI may be formed on first substrate 101.

First, device isolation layers 110 may be formed in the first substrate 101, and circuit gate dielectric layer 122 and circuit gate electrode 124 may be formed in order on the first substrate 101. The device isolation layers 110 may be formed, for example, by a shallow trench isolation (STI) process. The circuit gate dielectric layer 122 may be formed on the first substrate 101, and the circuit gate electrode 124 may be formed on the circuit gate dielectric layer 122. The circuit gate dielectric layer 122 and the circuit gate electrode 124 may be formed using atomic layer deposition (ALD) or chemical vapor deposition (CVD). The circuit gate dielectric layer 122 may be formed of silicon oxide, and the circuit gate electrode 124 may be formed of at least one of polycrystalline silicon or a metal silicide layer, but an example embodiment thereof is not limited thereto. Thereafter, spacer layers 126 may be formed on both sidewalls of the circuit gate dielectric layer 122 and the circuit gate electrode 124, and impurities may be implanted into the active region of the first substrate 101 on both sides of the circuit gate electrode 124 and may form source/drain regions 105.

The lower contact plugs 135 of the lower interconnection structure 130 may be formed by forming a portion of the lower capping layer 190, etching and removing a portion thereof, and filling a conductive material therein. Lower interconnection lines 137 may be formed, for example, by depositing a conductive material and patterning the material.

The lower bonding via 182 of the lower bonding structures 180 may be formed by forming a portion of the lower capping layer 190, etching and removing a portion thereof, and filling a conductive material therein. The lower bonding pad 184 may be formed, for example, by depositing a conductive material and patterning the material. The lower bonding structure 180 may be formed, for example, by a deposition process or a plating process. The lower bonding insulating layer 186 may be formed by covering a portion of an upper surface and a side surface of the lower bonding pad 184 and performing a planarization process until an upper surface of the lower bonding pad 184 is exposed.

The lower capping layer 190 may include a plurality of insulating layers. The lower capping layer 190 may become a portion in each of processes of forming the lower interconnection structure 130 and the lower bonding structure 180. Accordingly, the first semiconductor structure S1, the peripheral circuit region PERI, may be formed.

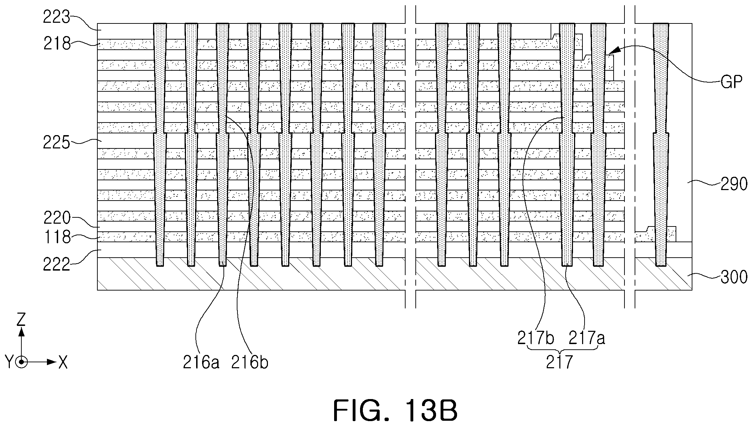

Referring to FIG. 13B, a process of manufacturing the second semiconductor structure S2 (CELL) may start.

Referring to FIG. 13B, the process of manufacturing the second substrate structure S2 (CELL) may start. The mold structures MS1 and MS2 may be formed by alternately stacking sacrificial insulating layers 118 and interlayer insulating layers 220 on a base substrate 300 (SUB), and sacrificial vertical structures 216 and 217 may be formed in positions in which vertical structures are formed, respectively.

The lower mold structure MS1 may be formed on the base substrate 300 on a level on which the first channel structures CH1 (see FIG. 4A) are disposed.

The base substrate 300 may include a semiconductor material, such as a group IV semiconductor, a group III-V compound semiconductor, or a group II-VI compound semiconductor.

At least a portion of the sacrificial insulating layers 218 may be replaced with a portion of the gate electrodes 230 (see FIG. 4A) through a subsequent process. The sacrificial insulating layers 218 may be formed of a material different from that of the interlayer insulating layers 220. For example, the interlayer insulating layer 220 and uppermost end, intermediate, lowermost interlayer insulating layers 222, 223, and 225 may be formed of at least one of silicon oxide and silicon nitride, and the sacrificial insulating layers 218 may be formed of a material different from that of the interlayer insulating layer 220 selected from among silicon, silicon oxide, silicon carbide and silicon nitride. In example embodiments, thicknesses of the interlayer insulating layers 220 may not be the same. Also, thicknesses of the interlayer insulating layers 220 and the sacrificial insulating layers 218 and the number of films included therein may be varied from the illustrated example.

The interlayer insulating layers 220 and the sacrificial insulating layers 218 included in the lower mold structure MS1 may be alternately stacked on the base substrate 300.

The gate pad region GP may be formed by repeatedly performing a photolithography process and an etching process for the sacrificial insulating layers 218 and the interlayer insulating layers 220. The gate pad regions GP may be formed in the second regions R2, and the sacrificial insulating layers 218 of the upper portion may be formed to include a region extending less than the sacrificial insulating layers 218 of the lower portion. In the gate pad region GP, asymmetrical step structures may be formed such that upper surfaces and ends of the plurality of sacrificial insulating layers 218 may be exposed upwardly. However, in example embodiments, a specific shape of the gate pad region GP may be varied. By further forming the sacrificial insulating layers 218 on the step structure of the gate pad regions GP, the sacrificial insulating layers 218 disposed in an uppermost portion of each region may be formed to have a relatively great thickness.

When forming a channel hole to form the vertical sacrificial structures 216a and 216b, a blocking structure may be formed selectively to maintain a uniform depth at which the channel hole is recessed into the base substrate 300.

A blocking structure (not illustrated) may be formed in a position in which a channel hole is formed in the base substrate 300 using a material having etching selectivity with respect to the base substrate 300 for anisotropic etching, and for example, the material may be metal material such as tungsten (W). When a channel hole is formed while the blocking structure is formed in each channel hole, the channel hole may not be formed below the sacrificial blocking structure due to the blocking structure. Thereafter, the blocking structure may be removed through the channel hole, and depending on the shape of the blocking structure, a channel structure CH having a head CH_a may be formed as illustrated in FIG. 9B.

Thereafter, a lower cell capping layer 290 covering the lower mold structure MS1 may be formed, and first vertical sacrificial layers 216a penetrating the lower mold structure MS1 may be formed.

The first vertical sacrificial layers 216a may be formed in a position corresponding to a lower portion of the first channel structures CH1 in the first region R1. The first contact sacrificial layers 217a may be formed in positions corresponding to contact plugs 270 (see FIG. 4A) in the first and second extension regions R2a and R2b. The first vertical sacrificial layers 216a and the first contact sacrificial layers 217a may be formed simultaneously. The first vertical sacrificial layers 216a and the first contact sacrificial layers 217a may be formed by forming holes to penetrate the lower mold structure MS1, depositing a sacrificial layer material in the holes, and performing a planarization process. The holes may include holes corresponding to channel structures CH, support structures 265, contact plugs 270, and external contact vias 275. Also, when the holes are formed, a plurality of isolation holes spaced apart from each other may be formed in a region corresponding to the isolation region MS, and a vertical sacrificial layer (not illustrated) filling the plurality of isolation holes may be formed together. For example, the vertical sacrificial layers including first vertical sacrificial layers 216a and first contact sacrificial layers 217a may include at least one of TiN and polycrystalline silicon.

Thereafter, the sacrificial insulating layers 218 and the interlayer insulating layers 220 forming the upper mold structure MS2 may be alternately stacked on the lower mold structure MS1, a step structure GP having a staircase shape may be formed, an upper capping layer 290 may be formed, second vertical sacrificial layers 216b and second contact sacrificial layer 217b may be formed.

Each of components of the upper mold structure MS2 may be formed in the same manner as the lower mold structure MS1.

The second vertical sacrificial layers 216b may be formed to be connected to the first vertical sacrificial layers 216a, respectively. The second contact sacrificial layers 217b may be formed to be connected to the first contact sacrificial layers 217a, respectively. The second vertical sacrificial layers 216b and the second contact sacrificial layers 217b may be formed by depositing the same material as that of the first vertical sacrificial layers 216a, for example, polycrystalline silicon. Also, the vertical sacrificial layers for the support structure 265, the vertical sacrificial layers for the insulating regions MS, and the vertical sacrificial layers for the external contact vias 275 may be formed by depositing the same material, for example, polycrystalline silicon.

Accordingly, the plurality of vertical sacrificial layers included in the vertical structures, the external contact vias 275, the channel structures CH, the support structures 265, the contact plugs 270 and the insulating region MS in FIGS. 4A and 4B may be formed simultaneously. By simultaneously forming holes for the vertical structures by an all-in-one HARC etching method, arcs formed on the base substrate 300 by high energy implantation for etching the mold structures MS1 and MS2 may be reduced.

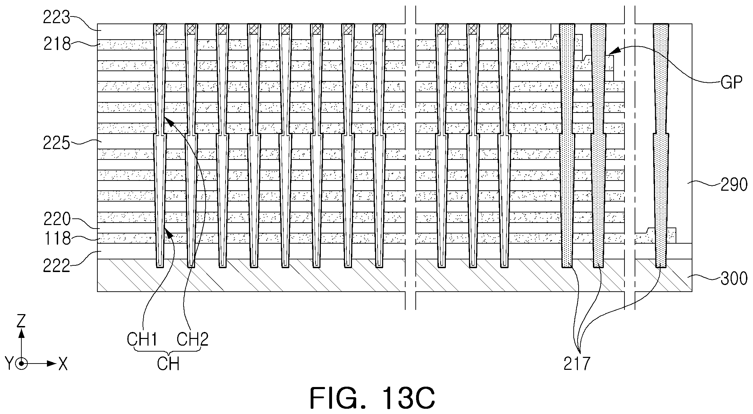

As illustrated in FIG. 13C, the channel structures CH penetrating the mold structures MS1 and MS2 of the sacrificial insulating layers 218 and the interlayer insulating layers 220 may be formed on the base substrate 300.

The channel structures CH may be formed by forming upper holes on the vertical sacrificial layers 216a and 216b, forming hole-shaped channel holes by removing the vertical sacrificial layers 216a and 216b, and filling the channel holes with a plurality of layers. The plurality of layers may include a data storage structure 245, a channel layer 240, a buried insulating layer 247, and a channel pad 249. The upper channel holes of the channel holes may be formed by anisotropically etching an upper stack structure of the sacrificial insulating layers 218 and the interlayer insulating layers 220 using a mask layer. The lower channel holes of the channel holes may be formed by removing the vertical sacrificial layer exposed through the upper channel holes.

Due to the height of the mold structures MS1 and MS2, a sidewall of the channel structures CH may not be vertical to an upper surface of the base substrate 300. The channel structures CH may be formed to be recessed into a portion of the base substrate 300, depending on a depth of the channel hole.

The data storage structure 245 may be formed to have a uniform thickness. In this process, the entirety or a portion of the data storage structure 245 may be formed, and a portion extending vertically to the base substrate 300 along the channel structures CH may be formed in this process. The channel layer 240 may be formed on the data storage structure 245 in the channel structures CH. The buried insulating layer 247 may be formed to fill the channel structures CH and may be an insulating material. The channel pad 249 may be formed of a conductive material, for example, polycrystalline silicon. The vertical structures 265 of the first and second extension regions R2a and R2b (see FIG. 3) may also be formed in a similar manner. Specifically, the support structures 265 may be formed by forming support holes by removing the vertical sacrificial layers, and filling the support holes with a support insulating layer.

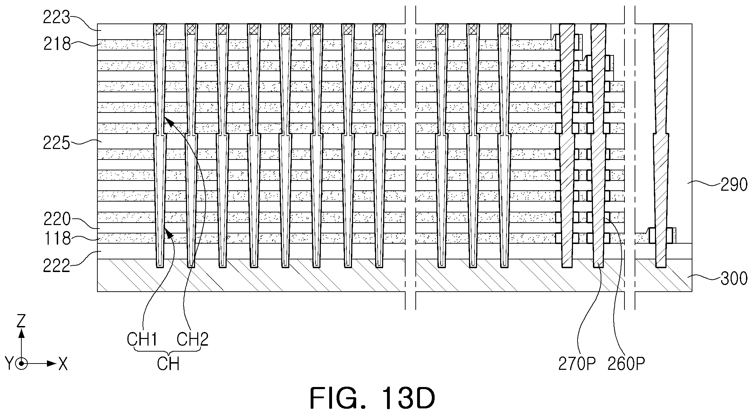

Referring to FIG. 13D, the preliminary contact insulating layers 260P and the vertical sacrificial layers 270P may be formed in a region corresponding to the contact plugs 270.

First, the contact sacrificial layers 217 in the region corresponding to the contact plugs 270 may be removed, and contact holes may be formed. A portion of the sacrificial insulating layers 218 exposed through the contact holes may be removed. Contact tunnel portions may be formed by removing the sacrificial insulating layers 218 to a desired and/or alternatively predetermined length around a perimeter of the contact holes. The contact tunnel portions may be formed to have a relatively short length in the sacrificial insulating layers 218 disposed in an uppermost portion, and may be formed to have a relatively long length in the sacrificial insulating layers 218 disposed in a lower portion.

Specifically, initially, alternatively, the contact tunnel portions may be formed to have a relatively long length in the sacrificial insulating layers 218 of the uppermost portion. This may be because the sacrificial insulating layers 218 in the uppermost portion include a region having a relatively higher etching rate than that of the sacrificial insulating layers 218 therebelow. Thereafter, a sacrificial layer may be formed in the contact holes and the contact tunnel portions. The sacrificial layer may be formed of a material of which an etch rate may be lower than that of the sacrificial insulating layers 218. Thereafter, a portion of the sacrificial layer and sacrificial insulating layers 218 may be removed. In this case, the sacrificial layer remains in an uppermost portion, and in the lower portion, a portion of the sacrificial insulating layers 218 may be removed after the sacrificial layer is removed. Accordingly, consequently, the contact tunnel portions may be formed to have a relatively short length in the sacrificial insulating layers 218 disposed in the uppermost portion.

By depositing an insulating material in the contact holes and the contact tunnel portions, preliminary contact insulating layers 260P may be formed. The preliminary contact insulating layers 260P may be formed on sidewalls of contact holes and may fill the contact tunnel portions. In the sacrificial insulating layers 218 in the uppermost portion, the preliminary contact insulating layers 260P may not completely fill the contact tunnel portions.

Vertical sacrificial layers 270P may fill contact holes and the contact tunnel portions disposed in an uppermost portion. The vertical sacrificial layers 270P may include a different material from that of the preliminary contact insulating layers 260P, for example, polycrystalline silicon.

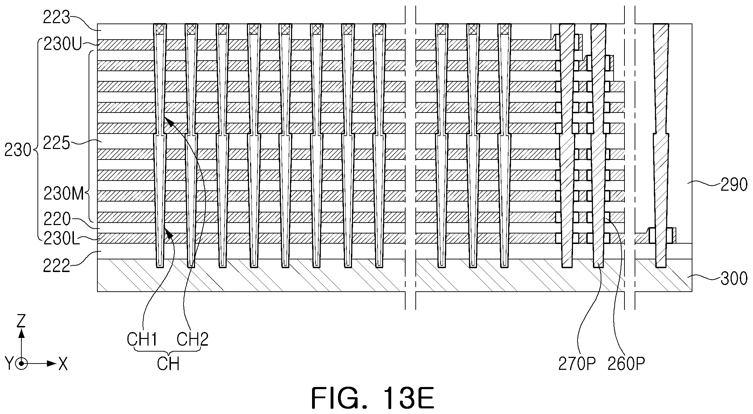

As illustrated in FIG. 13E, the vertical sacrificial layer filling the isolation holes formed in a position of the isolation regions MS may be removed, and the isolation holes may be extended through cleaning and may be connected to each other in the X-direction as illustrated in FIG. 3, thereby forming openings connected to each other. As the plurality of isolation holes extend in a circumferential direction and are connected to each other, a side surface forming the isolation region MS may have a shape in which an outwardly curved line is continuously formed. Through wet etching in the extended openings, the sacrificial insulating layers 218 may be selectively removed with respect to the interlayer insulating layers 220 and the preliminary contact insulating layers 260P, and the gate electrodes 230 may be formed.

The gate electrodes 230 may be formed by depositing a conductive material in regions from which the sacrificial insulating layers 218 have been removed. The conductive material may include metal, polycrystalline silicon, or a metal silicide material. In some example embodiments, a portion of the gate dielectric layer may first be formed before the gate electrodes 230 is formed.

After the gate electrodes 230 is formed, gate isolation insulating layers 264 (see FIG. 4B) may be formed in the openings formed to correspond to the isolation regions MS.

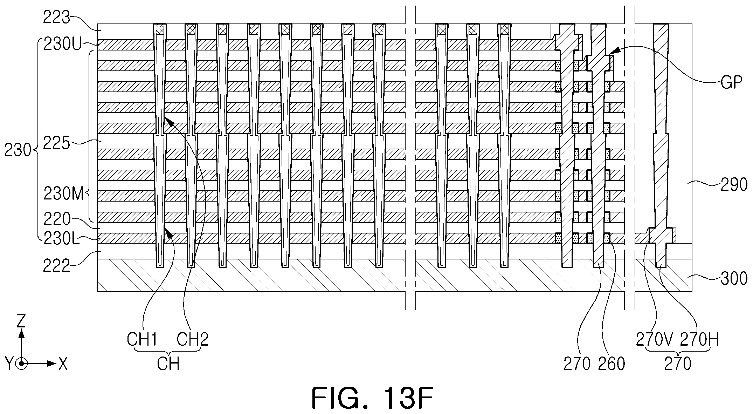

Referring to FIG. 13F, contact plugs 270 may be formed.

The vertical sacrificial layers 270P corresponding to the contact plugs 270 may be removed, and a portion of the preliminary contact insulating layers 260P may be removed.

The vertical sacrificial layers 270P may be selectively removed with respect to the interlayer insulating layers 220 and the gate electrodes 230. After the exposed vertical sacrificial layers 270P are removed, a portion of the preliminary contact insulating layers 260P may also be removed. In this case, the entirety of the preliminary contact insulating layers 260P may be removed from the gate electrodes 230 of the uppermost portion corresponding to the contact regions, and may remain therebelow, such that contact insulating layers 260 may be formed. In contact regions, when the gate dielectric layer is exposed after the preliminary contact insulating layers 260P are removed, a side surface of the gate electrodes 230 may be exposed by removing the gate dielectric layer.

The contact plugs 270 and the external contact vias 275 may be formed.

The contact plugs 270 and the external contact vias 275 may be formed by depositing a conductive material in the removed contact hole. The contact plugs 270 may be formed to have horizontal extension portions 270H (see FIG. 4A) extending horizontally from the contact regions, and may be physically and electrically connected to the gate electrodes 230. The external contact vias 275 may be deposited together with the contact plugs 270, or may be deposited in another process.

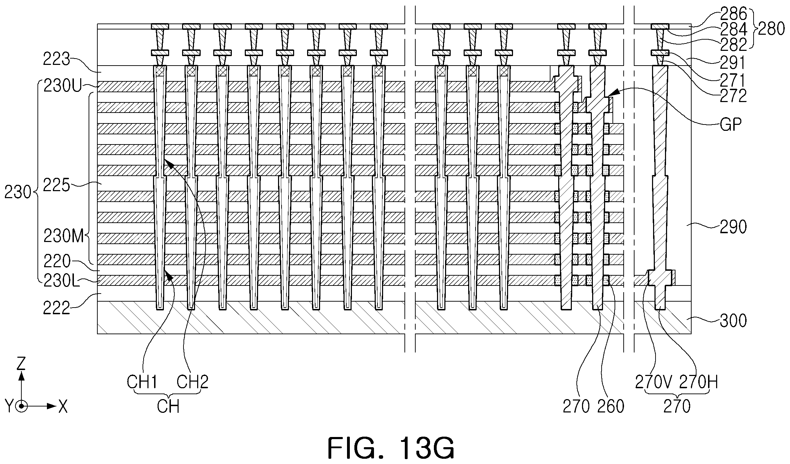

Referring to FIG. 13G, upper interconnection structures 271 and 272 including studs 272 and upper interconnections 271 may be formed, and an upper bonding structure 280 may be formed.

In the first region R1 and the studs 272 may be formed to be connected to the channel structures CH. In the first and second extension regions R2a and R2b, the studs 272 may be configured to be connected to the contact plugs 270. Also, the studs 272 connected to the external contact vias 275 may also be formed in the first and second extension regions R2a and R2b. Each of the studs 272 may be connected to the upper interconnections 271 vertically, and may be connected in multiple layers through plugs.

Thereafter, the upper bonding structure 280 may be formed in a similar manner to the forming of the lower bonding structure 180. Accordingly, a second semiconductor structure S2, a memory cell structure CELL, may be formed. However, during the process of manufacturing the semiconductor device 10, the second semiconductor structure S2 may further include a base substrate 300.

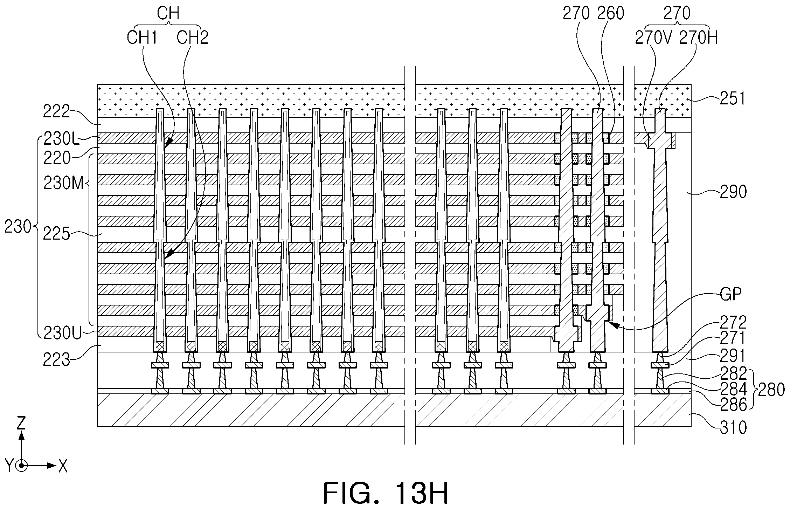

Referring to FIG. 13H, the stack structure GS1 and GS2 in which the base substrate 300 is formed may be transferred to the carrier substrate 310 and may be disposed upside down such that the lower base substrate 300 may be exposed upwardly.

Specifically, when the stack structures GS1 and GS2 are disposed upside down such that the upper bonding structure 280 is in contact with the carrier substrate 310, the channel structures CH, the insulating regions MS, the contact plugs 270 and the external contact vias 275 may be disposed reversely such that widths thereof may increase downwardly below the base substrate 300 exposed in an upper portion. Thereafter, the base substrate 300 may be removed and lowermost portions of the lowermost interlayer insulating layer 222 and the channel structures CH, and the contact plugs 270 may be formed to protrude. In this case, by not forming a layer between the base substrate 300 as an etch prevention film for the channel structures CH, removal of the base substrate 300 may be performed at a relatively high speed. Thereafter, a protective layer 251 may be formed on an uppermost surface of the exposed stack structures GS1 and GS2. The protective layer 251 may cover the entire mat MAT and may be formed to have a desired and/or alternatively predetermined thickness. The desired and/or alternatively predetermined thickness may be formed to correspond to a height of the cell guide structure CD, and may be 300 to 500 nm. Plasma CVD may be entirely performed on the protective layer 251 by applying PE-SiN, and the process may be performed in a hydrogen atmosphere, thereby forming an H-rich SiN layer including a substantial amount of hydrogen.

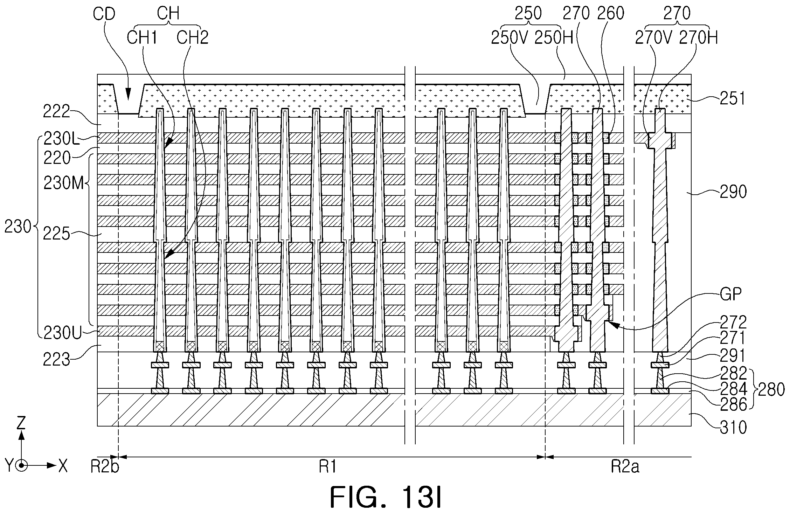

As illustrated in FIG. 13I, an opening may be formed in a region surrounding the first region R1 in the protective layer 251. The opening may be performed until an upper surface of the lowermost interlayer insulating layer 222 is exposed, and may be selectively formed in the region in which the cell guide structure CD in FIG. 2 is disposed. The opening may be formed by selectively removing the protective layer 251 using a mask pattern, and may be formed to have an inclined side surface such that a width of an upper portion of the opening may be larger than a width of a lower portion. By filling the opening, a cell guide insulating layer 250 may be formed on the protective layer 251. The cell guide insulating layer 250 may form a cell guide structure region 250V filling the opening, may be formed with a sufficient thickness to cover the protective layer 251, and an oxide film may be deposited to have a desired and/or alternatively predetermined thickness on the protective layer 251, thereby forming an extension guide region 250H on the protective layer 251. Through the deposition, a cell guide structure CD as illustrated in FIG. 3 may be formed to have a frame shape in the opening, and may function as a dam defining the memory cell region R1 and the other regions in a subsequent process.

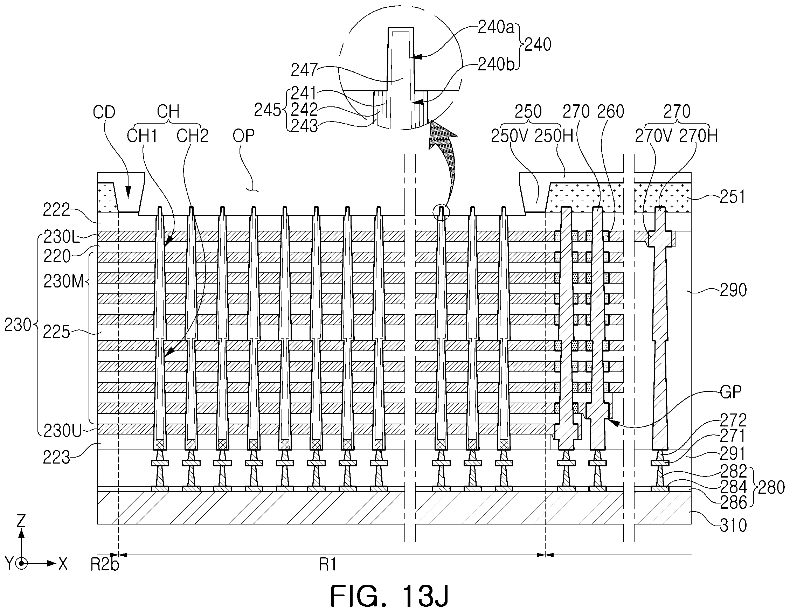

Thereafter, as illustrated in FIG. 13J, the first region opening OP may be formed by selectively removing the protective layer 251 in a frame of the cell guide structure CD.

The first region opening OP may be formed along an internal side surface of the cell guide structure CD, such that an angle formed by a side surface and a bottom surface may form an acute angle, and may have a shape having a width decreasing upwardly.

The data storage structure 245 on a second portion of the channel structure CH exposed in the first region opening OP may be removed. The data storage structure 245 may be removed by a photolithography process and an etching process such as wet etching and/or dry etching. Accordingly, in the first region opening OP, in the second portion of the channel structure CH protruding to the stack structures GS1 and GS2, the channel layer 240 may be exposed and the protrusion portion 240a may be disposed. Accordingly, when the subsequent process is performed, the channel layer 240 of the second portion may be in direct contact with the first conductive layer 201. In this case, an etching process for continuously removing an oxide film, nitride film, and oxide film may be performed, and a portion of the uppermost end interlayer insulating layer 222 including the oxide may be etched together such that an upper surface of the uppermost end interlayer insulating layer 222 in the first region opening OP may be lowered to have a level lower than a level of a lower surface of the cell guide structure CD and the lower surface of the protective layer 251. When the reflective structure RS is included as illustrated in FIGS. 7 and 8, each stack pair forming the reflective structure RS may be formed in which on the guide insulating layer 250.

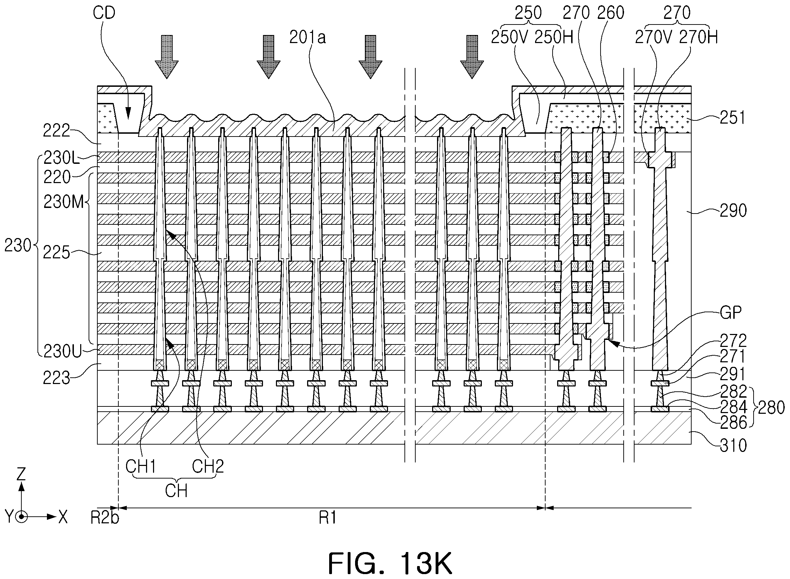

Thereafter, as illustrated in FIG. 13K, the first conductive layer 201 may be formed to cover the entire mat MAT. The first conductive layer 201 may be formed by depositing a semiconductor layer, specifically a crystalline silicon layer, for example, a polycrystalline silicon layer 201a. In this case, the polycrystalline silicon layer 201a formed entirely on an upper surface of mat MAT may be formed to have inflection along the channel structures CH protruding in the first region opening OP. Accordingly, a thickness of the polycrystalline silicon layer 201a on the protective layer 251 and a thickness of the polycrystalline silicon layer 201a in the first region opening OP may be different.

In this case, a melting laser annealing (MLA) process may be performed to activate the polycrystalline silicon layer 201a. In the MLA process, impurities in the polycrystalline silicon layer 201a may be diffused and crystals are recrystallized through laser annealing, and the MLA process may be performed by a high-temperature, high-energy laser, and may be performed simultaneously for the entire mat MAT. During the MLA process, the first and second extension regions R2a and R2b and the edge region EA in which the protective layer 251 is formed may not transmit energy and heat to a lower portion as the protective layer 251 absorbs high energy and heat. Accordingly, the interconnection structures 271 and 272 including copper disposed in a lower portion of the stack structure GS1 and GS2 may not be affected, such that defects of migration of copper metal may be limited and/or prevented. Through the MLA process, the process in which the polycrystalline silicon layer 201a is melted and re-crystallized may be performed, and an upper surface of the polycrystalline silicon layer 201a in the first region opening OP, which has inflection, may be formed to be flat, thereby forming the first conductive layer 201. Accordingly, the first conductive layer 201 in the first region R1 may have a flat upper surface, and a thickness h2 thereof may have a value larger than a thickness h4 of the first conductive layer 201 on the cell guide structure CD.

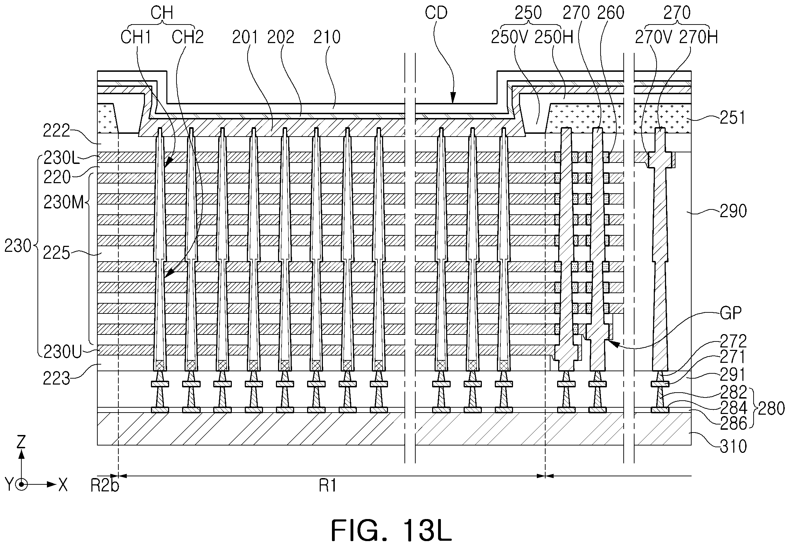

As illustrated in FIG. 13L, a second conductive layer 202 may be formed on a first conductive layer 201 and a buffer layer 205 may be formed continuously. Specifically, the second conductive layer 202 may be formed by successively depositing an ohmic contact layer 202b, a conductive metal layer 202a and a diffusion barrier 202c, and a thickness of the conductive metal layer 202a may be formed to have a significantly large value. The buffer layer 205 may be formed conformally to completely cover the second conductive layer 202, and an oxide film, for example, a silicon oxide film, may be formed as the buffer layer 205.

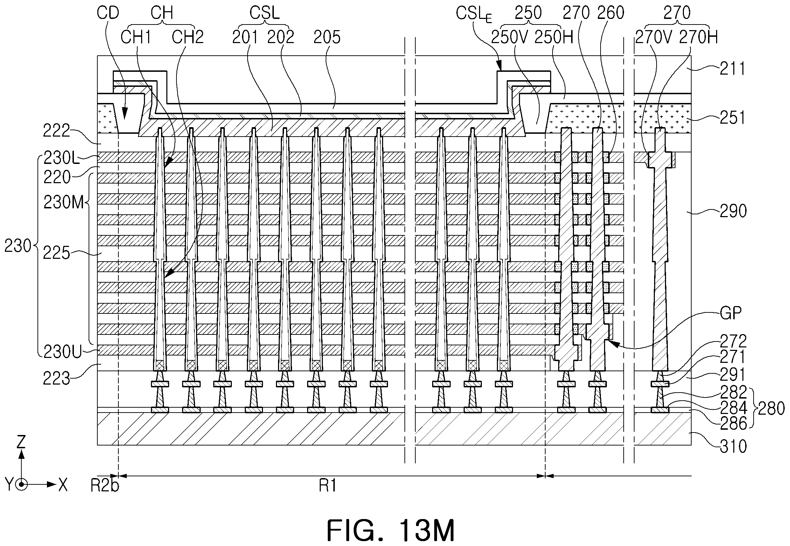

As illustrated in FIG. 13M, the first conductive layer 201, the second conductive layer 202 and the buffer layer 205 may be disposed in the first region R1 and may be etched to not extend to the first and second extension regions R2a and R2b and the edge region EA. The etching of the first conductive layer 201, the second conductive layer 202 and the buffer layer 205 may be performed through a mask pattern, and may be patterned to have an extension region CSL_{E} covering an upper surface of the cell guide structure CD, as illustrated in FIG. 4A, or may be formed as illustrated in FIG. 6A or FIG. 6B. Thereafter, an upper surface may be formed to be flat by forming the first insulating layer 211 with a desired and/or alternatively predetermined thickness on the mat MAT entirely.

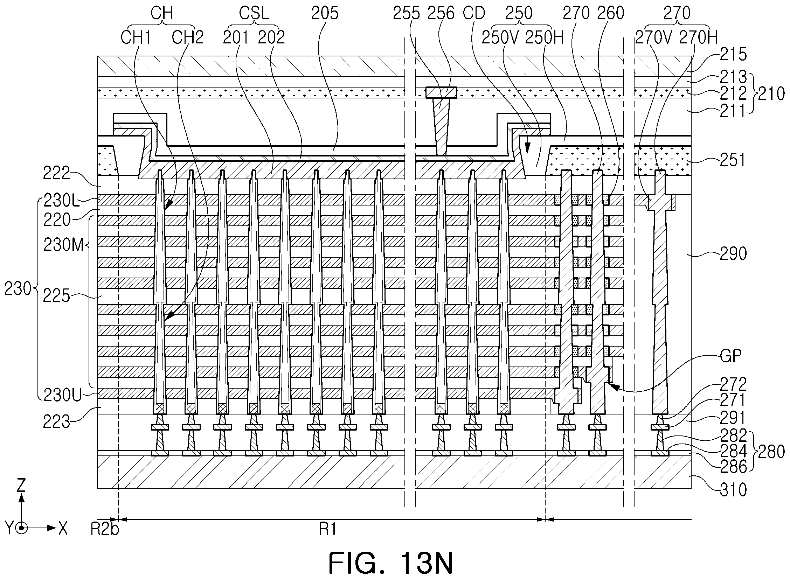

As illustrated in FIG. 13N, the second insulating layer 212 and the hydrogen supply layer 213 may be successively formed on the first insulating layer 211 and the upper insulating structure 210 may be formed, and by forming the passivation layer 215, the upper structure may be completed. Specifically, a second insulating layer 212 and hydrogen supply layer 213 may be further formed on the first insulating layer 211, the first insulating layer 211 to the hydrogen supply layer 213 may be opened to form the source contact via 255, and the source interconnection 256 connected to the source contact via 255 may be formed in the second insulating layer 212 or the hydrogen supply layer 213. A plurality of the common contact vias 255 may be formed in a mat MAT and may transmit common source voltage to the common source line CSL simultaneously, and source interconnections 256 for the transmission may be connected to each other. A passivation layer 215 may be formed to cover the common source line CSL. The passivation layer 215 may be planarized by a polishing process such as a grinding process or a chemical mechanical polishing process. In the subsequent process, a portion of the passivation layer 215 may be removed and the input/output pad region 258 may be formed, but the process is not limited thereto.

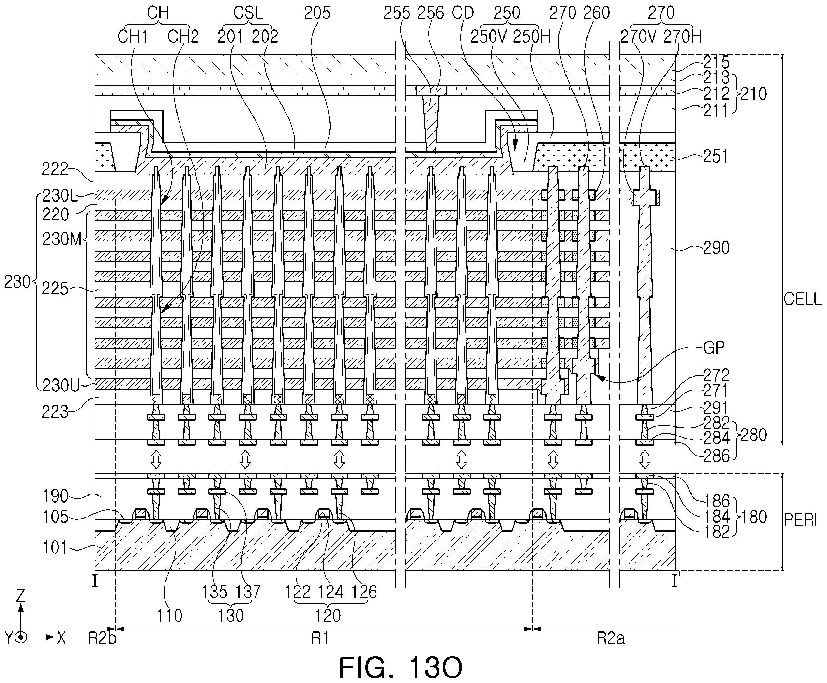

As illustrated in FIG. 13O, the first semiconductor structure S1, the peripheral circuit structure PERI, and the second semiconductor structure S2, the memory cell structure CELL, may be bonded to each other.

The second semiconductor structure S2 isolated from the first semiconductor structure S1 and the carrier substrate 310 may be connected to each other by bonding the lower bonding pad 184 to the upper bonding pad 284 by applying pressure. The lower bonding insulating layer 186 and the upper bonding insulating layer 286 may be connected to each other by bonding with pressure. The second semiconductor structure S2 may be bonded to the first semiconductor structure S1 for the upper bonding pad 284 to face downwardly. The first semiconductor structure S1 and the second semiconductor structure S2 may be directly bonded to each other without an adhesive such as an adhesive layer therebetween.

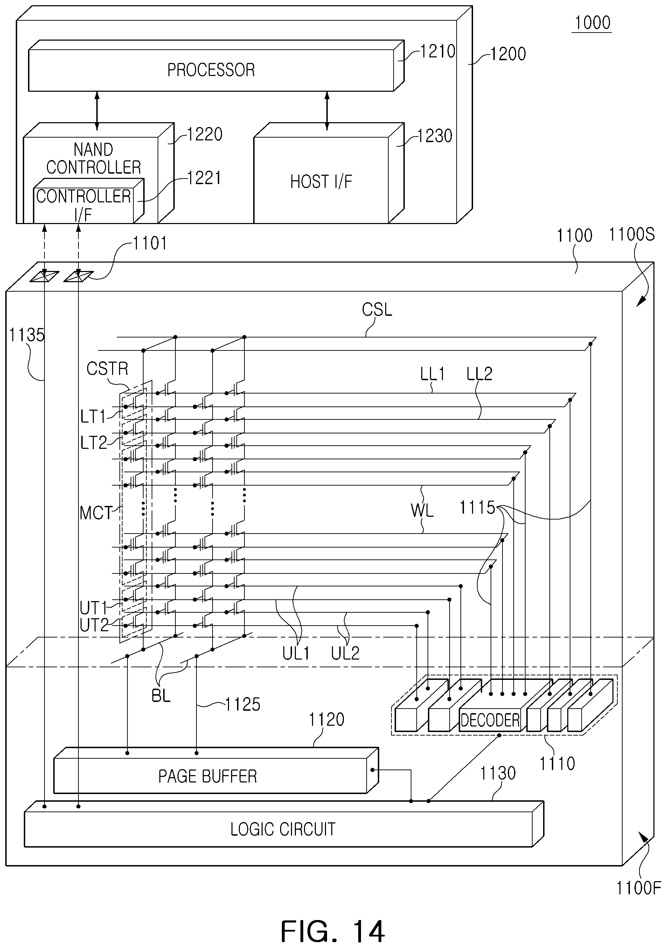

FIG. 14 is a diagram illustrating a data storage system including a semiconductor device according to an example embodiment.

Referring to FIG. 14, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned example embodiment with reference to FIGS. 1 to 5B. The semiconductor device 1100 may include a first structure 1100F and a second structure 1100S on the first structure 1100F. In the example embodiments, the first structure 1100F may be disposed on the side of the second structure 1100S. The first structure 1100F may be implemented as a peripheral circuit structure including a decoder circuit 1110, a page buffer 1120, and a logic circuit 1130. The second structure 1100S may be implemented as a memory cell structure including a bitline BL, a common source line CSL, wordlines WL, first and second gate upper lines UL1 and UL2, first and second gate lower lines LL1 and LL2 and memory cell strings CSTR disposed between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in the example embodiments.

In the example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The wordlines WL may be configured as gate electrodes of the memory cell transistors MCT, and the gate upper lines UL1 and UL2 may be configured as gate electrodes of the upper transistors UT1 and UT2, respectively.

In the example embodiments, the lower transistors LT1 and LT2 may include a lower erase control transistor LT1 and a ground select transistor LT2 connected to each other in series. The upper transistors UT1 and UT2 may include string select transistors UT1 and UT2 connected to each other in series.

The common source line CSL, the first and second gate lower lines LL1 and LL2, the wordlines WL, and the first and second gate upper lines UL1 and UL2 may be electrically connected to the decoder circuit 1110 through first connection interconnections 1115 extending from the first structure 1100F to the second structure 1100S. The bitlines BL may be electrically connected to the page buffer 1120 through second connection interconnections 1125 extending from the first structure 110F to the second structure 11005.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In the example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a desired and/or alternatively predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

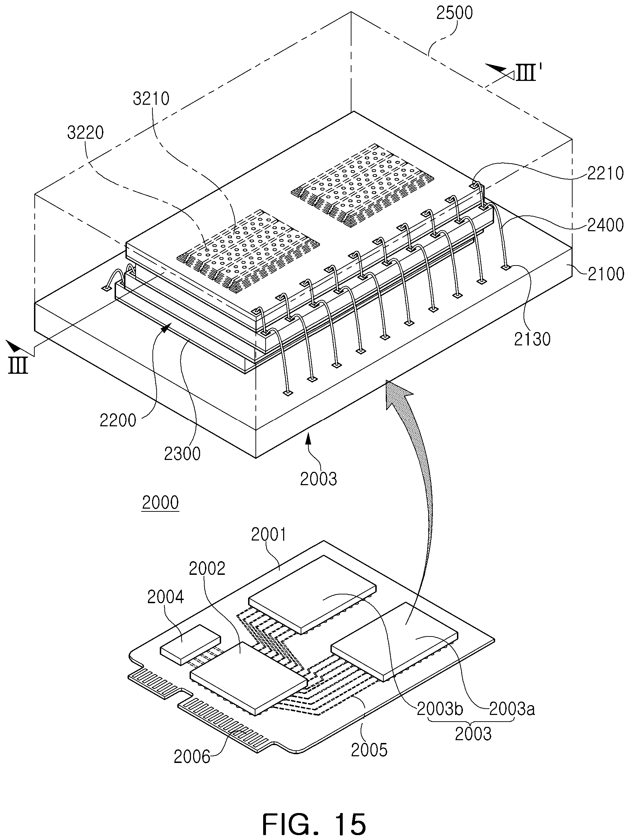

FIG. 15 is a perspective diagram illustrating a data storage system including a semiconductor device according to an example embodiment.

Referring to FIG. 15 a data storage system 2000 in an example embodiment may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may be varied depending on a communication interface between the data storage system 2000 and the external host. In the example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In the example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 14, and may be a region including the pad region 258 in FIG. 4B. Each of the semiconductor chips 2200 may include gate stack structures 3210 and channel structures 3220. Each of the semiconductor chips 2200 may include the semiconductor device described in the aforementioned example embodiment with reference to FIGS. 1 to 12.

In the example embodiments, the connection structure 2400 may be configured as a bonding wire electrically connecting the input/output pad 2210 to the upper package pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In the example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In the example embodiments, the controller 2002 and the semiconductor chips 2200 may be included in a single package. In an example embodiment, the controller 2002 and the semiconductor chips 2200 may be mounted on an interposer substrate different from the main board 2001, and the controller 2002 and the semiconductor chips 2200 may be connected to each other by interconnection formed on the interposer substrate.

FIG. 16 is a cross-sectional diagram illustrating a semiconductor package according to an example embodiment

FIG. 16 illustrates an example embodiment of the semiconductor package 2003 in FIG. 15 taken along line III-III'.

Referring to FIG. 16, in a semiconductor package 2003A, the package substrate 2100 may be implemented as a printed circuit substrate. The package substrate 2100 may include may include a package substrate body portion 2120, package upper pads 2130 disposed on an upper surface of the package substrate body portion 2120 (see FIG. 15), lower pads 2125 disposed on the lower surface of the package substrate body 2120 or exposed through the lower surface, and internal interconnections 2135 electrically connecting the upper pads 2130 to the lower pads 2125 in the package substrate body 2120. The lower pads 2125 may be connected to the interconnection patterns 2005 of the main the substrate 2001 of the data storage system 2000 through the conductive connection portions 2800 as illustrated in FIG. 15.

In the semiconductor package 2003A, each of the semiconductor chips 2200a may have a semiconductor substrate 4010, a first semiconductor structure 4100 on the semiconductor substrate 4010, and a second semiconductor structure 4200 bonded to the first semiconductor structure 4100 using a wafer bonding method on the first semiconductor structure 4100.

The first semiconductor structure 4100 may include a peripheral circuit region including a peripheral interconnection 4110 and a lower bonding structure 4150. The second semiconductor structure 4200 may include a common source line 4205, a gate stack structure 4210 between the common source line 4205 and a first semiconductor structure 4100, channel structures 4220 and an isolation structure 4230 penetrating the gate stack structure 4210, and an upper bonding structure 4250 electrically connected to wordlines of the channel structures 4220 and the gate stack structure 4210, respectively. For example, the upper junction structure 4250 may be electrically connected to the channel structures 4220 and word lines, respectively, through the contact plugs 270 electrically connected to the bit lines 4240 and word lines, which may be electrically connected to the channel structures 4220. The lower bonding structure 4150 of the first semiconductor structure 4100 and the upper bonding structure 4250 of the second semiconductor structure 4200 may be in contact with each other and bonded to each other. The bonded portions of the lower bonding structure 4150 and the upper bonding structure 4250 may be formed of copper (Cu), for example.

As illustrated in the enlarged diagram, the second semiconductor structure 4200 may include a cell guide structure CD defining the first region R1, and a protective layer 251, a nitride film, may be disposed externally of the first region R1, thereby protecting the lower interconnection structures while the MLA process is performed on the common source line CSL in the first region R1.

Each of the semiconductor chips 2200 may further include an input/output pad 2210 and an input/output interconnection 4235 below the input/output pad 2210. The input/output interconnection 4235 may be electrically connected to a portion of the second bonding structures 4250. The input/output pad 2210 may be a region including the pad region 258.

The semiconductor chips 2200 in FIG. 16 may be electrically connected to each other by the connection structures 2400 in a shape of bonding wires. However, in example embodiments, semiconductor chips in a semiconductor package, such as the semiconductor chips 2200 in FIG. 15, may be electrically connected to each other by a connection structure including a through electrode (TSV).

According to the aforementioned example embodiments, in a structure in which two or more substrate structures are bonded, a cell guide structure may be formed on a stack structure exposed from a back surface of an upper substrate structure to distinguish the cell region from the extension region, a nitride film may be formed as a protective layer on the extension region, and a common source line may be formed on each cell region. When activation through laser annealing is performed on the silicon layer disposed as a common source line on the cell region, energy caused by laser annealing may be blocked from reaching the front surface of the extension region by a protective layer, defects caused by metal migration of the multiple interconnection structures disposed in the front surface of the extension region, especially copper diffusion, may be limited and/or prevented. Also, by forming at least one additional pair of reflective structures on the protective layer, energy may be more effectively limited and/or prevented from being transmitted to the interconnection structures below.

Also, by applying H-rich nitride as a protective layer, and hydrogen may be provided to the channel structure, activation of each channel layer may be easily performed.

By forming the cell guide structure after replacement of the gate electrodes, and by forming the cell guide structure in the base substrate before forming the channel structure, the issues such as leakage current caused by residual metal material in the intersection region of the cell guide structure and isolation regions may be limited and/or prevented when metal in the gate electrodes is substituted through opening of the isolation region.

Accordingly, the semiconductor device having improved reliability and a data storage system including the same may be provided.

One or more of the elements disclosed above may include or be implemented in processing circuitry such as hardware including logic circuits; a hardware/software combination such as a processor executing software; or a combination thereof. For example, the processing circuitry may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While the example embodiments have been illustrated and described above, it will be configured as apparent to those skilled in the art that modifications and variations could be made without departing from the scope of the present disclosure as defined by the appended claims.

Embodiments are set out in the following clauses:
1. A semiconductor device, comprising:
   a first semiconductor structure including a first substrate, circuit devices on the first substrate, a lower interconnection structure electrically connected to the circuit devices, and a lower bonding structure connected to the lower interconnection structure; and
   a second semiconductor structure connected to the first semiconductor structure and on the first semiconductor structure,
   wherein the second semiconductor structure includes
      a stack structure including interlayer insulating layers and gate electrodes stacked vertically in a first region of the stack structure and a second region of the stack structure,
      an upper interconnection structure below the stack structure,
      an upper bonding structure connected to the upper interconnection structure and bonded to the lower bonding structure,
      a cell guide structure on an upper portion of the stack structure and dividing the first region of the stack structure and the second region of the stack structure,
      channel structures each including a first portion and a second portion, the first portion penetrating the stack structure in a vertical direction in the first region of the stack structure, and the second portion extending upwardly from the first portion in the first region of the stack structure,
      contact plugs penetrating the stack structure in the vertical direction and being connected to contact regions of the gate electrodes in the second region of the stack structure,
      a first conductive layer in contact with an internal side surface of the cell guide structure in the first region of the stack structure, the first conductive layer on an upper portion of the stack structure and connected to the second portion of the channel structures, and
      a protective layer in contact with an external side surface of the cell guide structure in the second region of the stack structure, the protective layer being on the upper portion of the stack structure.
2. The semiconductor device of clause 1, wherein
   the protective layer includes nitride, and
   the first conductive layer includes a crystalline semiconductor.
3. The semiconductor device of clause 1 or clause 2, wherein,
   in the first region of the stack structure, a thickness of the first conductive layer is greater than a length of the second portion of the channel structures, and an area of an upper surface of the first conductive layer is less than an area of a lower surface of the first conductive layer.
4. The semiconductor device of any preceding clause, wherein
   the first conductive layer includes a source region and an extension region,
   the source region of the first conductive layer covers the stack structure in the first region of the stack structure,
   the extension region is bent from the source region and extends along the internal side surface of the cell guide structure, and
   a thickness of the source region of the first conductive layer is greater than a thickness of the extension region of the first conductive layer.
5. The semiconductor device of any preceding clause, further comprising:
   an extension insulating layer extending from an upper portion of the cell guide structure to the protective layer, wherein
   a thickness of the extension insulating layer is smaller than a thickness of the cell guide structure.
6. The semiconductor device of any preceding clause, wherein
   a lower surface of the protective layer and a lower surface of the cell guide structure are coplanar with each other, and
   a level of a lower surface of the first conductive layer is lower than a level of the lower surface of the protective layer.
7. The semiconductor device of any preceding clause, wherein
   the second semiconductor structure further includes a second conductive layer disposed along the first conductive layer and on the first conductive layer in the first region of the stack structure.
8. The semiconductor device of any preceding clause, further comprising:
   a reflective structure on the protective layer, the reflective structure having a layered structure including a first material layer and a second material layer on the first material layer, a material of the second material layer being different from a material of the first material layer, wherein
   the reflective structure does not overlap the channel structures in the vertical direction.
9. The semiconductor device of clause 8, wherein
   the first material layer includes oxide, and
   the second material layer includes nitride.
10. The semiconductor device of clause 8 or clause 9, wherein
   the reflective structure includes a plurality of first material layers and a plurality of second material layers, which are alternately stacked,
   the plurality of first material layers include the first material layer, and
   the plurality of second material layers include the second material layer.
11. The semiconductor device of any of clauses 8 to 10, wherein the reflective structure overlaps the cell guide structure in the vertical direction.
12. The semiconductor device of any preceding clause, wherein
   the protective layer includes H-rich SiN and is configured to provide a hydrogen path to the channel structures.
13. A semiconductor device, comprising:
   a stack structure including interlayer insulating layers and gate electrodes stacked in a vertical direction, the stack structure including a first region and a second region;
   a cell guide structure on the stack structure and defining the first region of the stack structure;
   a first conductive layer on the stack structure in the first region of the stack structure and in contact with the cell guide structure;
   a protective layer on the second region of the stack structure; and
   channel structures each including a first portion and a second portion, the first portion penetrating the stack structure in the vertical direction and the second portion extending upwardly from the first portion and including a channel layer in direct contact with the first conductive layer, the channel structures being on the first region of the stack structure,
   wherein a side surface of the first conductive layer and a lower surface of the first conductive layer form an acute angle on an interfacial surface between the first conductive layer and the cell guide structure.
14. The semiconductor device of clause 13, wherein
   the cell guide structure has a frame shape on the stack structure, and a region of the frame shape and an internal portion of the frame shape define the first region of the stack structure.
15. The semiconductor device of clause 14, wherein
   a thickness of the first conductive layer is greater than a length of the second portion of the channel structures, and
   an area of an upper surface of the first conductive layer is smaller than an area of a lower surface of the first conductive layer in the first region of the stack structure.
16. The semiconductor device of any of clauses 13 to 15,
   wherein a lower surface of the protective layer and a lower surface of the cell guide structure are coplanar with each other, and
   wherein a level of a lower surface of the first conductive layer is lower than a level of the lower surface of the protective layer.
17. The semiconductor device of any of clauses 13 to 16, further comprising:
   dummy channel structures penetrating the stack structure in the vertical direction and
   extending into a lower portion of the cell guide structure.
18. The semiconductor device of clause 17, further comprising:
   a channel dielectric layer covering a channel layer of the second portion of the channel structures.
19. A data storage system, comprising:
   a semiconductor storage device including
      a first semiconductor structure including a substrate and circuit devices on the substrate, and
      a second semiconductor structure including a stack structure and an input/output pad,
      the stack structure including interlayer insulating layers and gate electrodes stacked in a vertical direction in a first region and a second region of the stack structure,
      the stack structure further including channel structures each including a first portion and a second portion, the first portion penetrating the stack structure in the vertical direction in the first region of the stack structure and the second portion extending upwardly from the first portion in the first region, and
      the input/output pad being electrically connected to the circuit devices; and
   a controller electrically connected to the semiconductor storage device through the input/output pad and configured to control the semiconductor storage device,
   wherein the first semiconductor structure further includes a lower interconnection structure electrically connected to the circuit devices and a lower bonding structure connected to the lower interconnection structure,
   wherein the second semiconductor structure includes
      an upper interconnection structure below the stack structure,
      an upper bonding structure connected to the upper interconnection structure and bonded to the lower bonding structure,
      a cell guide structure on an upper portion of the stack structure and dividing the first region of the stack structure and the second region of the stack structure,
      contact plugs penetrating the stack structure in the vertical direction and being connected to contact regions of the gate electrodes in the second region of the stack structure,
      a first conductive layer in contact with an internal side surface of the cell guide structure in the first region of the stack structure, the first conductive layer on an upper portion of the stack structure and connected to the second portion of the channel structure, and
   a protective layer in contact with an external side surface of the cell guide structure in the second region of the stack structure, the protective layer being on the upper portion of the stack structure.
20. The data storage system of clause 19, wherein
   a thickness of the first conductive layer is greater than a length of the second portion of the channel structures, and
   an area of an upper surface of the first conductive layer is smaller than an area of a lower surface in the first region of the stack structure.

## Claims

1. A semiconductor device, comprising:
a first semiconductor structure including a first substrate, circuit devices on the first substrate, a lower interconnection structure electrically connected to the circuit devices, and a lower bonding structure connected to the lower interconnection structure; and
a second semiconductor structure connected to the first semiconductor structure and on the first semiconductor structure,
wherein the second semiconductor structure includes
a stack structure including interlayer insulating layers and gate electrodes stacked vertically in a first region of the stack structure and a second region of the stack structure,
an upper interconnection structure below the stack structure,
an upper bonding structure connected to the upper interconnection structure and bonded to the lower bonding structure,
a cell guide structure on an upper portion of the stack structure and dividing the first region of the stack structure and the second region of the stack structure,
channel structures each including a first portion and a second portion, the first portion penetrating the stack structure in a vertical direction in the first region of the stack structure, and the second portion extending upwardly from the first portion in the first region of the stack structure,
contact plugs penetrating the stack structure in the vertical direction and being connected to contact regions of the gate electrodes in the second region of the stack structure,
a first conductive layer in contact with an internal side surface of the cell guide structure in the first region of the stack structure, the first conductive layer on an upper portion of the stack structure and connected to the second portion of the channel structures, and
a protective layer in contact with an external side surface of the cell guide structure in the second region of the stack structure, the protective layer being on the upper portion of the stack structure.

2. The semiconductor device of claim 1, wherein
the protective layer includes nitride, and
the first conductive layer includes a crystalline semiconductor.

3. The semiconductor device of claim 1 or claim 2, wherein,
in the first region of the stack structure, a thickness of the first conductive layer is greater than a length of the second portion of the channel structures, and an area of an upper surface of the first conductive layer is less than an area of a lower surface of the first conductive layer.

4. The semiconductor device of any preceding claim, wherein
the first conductive layer includes a source region and an extension region,
the source region of the first conductive layer covers the stack structure in the first region of the stack structure,
the extension region is bent from the source region and extends along the internal side surface of the cell guide structure, and
a thickness of the source region of the first conductive layer is greater than a thickness of the extension region of the first conductive layer.

5. The semiconductor device of any preceding claim, further comprising:
an extension insulating layer extending from an upper portion of the cell guide structure to the protective layer, wherein
a thickness of the extension insulating layer is smaller than a thickness of the cell guide structure.

6. The semiconductor device of any preceding claim, wherein
a lower surface of the protective layer and a lower surface of the cell guide structure are coplanar with each other, and
a level of a lower surface of the first conductive layer is lower than a level of the lower surface of the protective layer.

7. The semiconductor device of any preceding claim, wherein
the second semiconductor structure further includes a second conductive layer disposed along the first conductive layer and on the first conductive layer in the first region of the stack structure.

8. The semiconductor device of any preceding claim, further comprising:
a reflective structure on the protective layer, the reflective structure having a layered structure including a first material layer and a second material layer on the first material layer, a material of the second material layer being different from a material of the first material layer, wherein
the reflective structure does not overlap the channel structures in the vertical direction.

9. The semiconductor device of claim 8, wherein
the first material layer includes oxide, and
the second material layer includes nitride.

10. A semiconductor device, comprising:
a stack structure including interlayer insulating layers and gate electrodes stacked in a vertical direction, the stack structure including a first region and a second region;
a cell guide structure on the stack structure and defining the first region of the stack structure;
a first conductive layer on the stack structure in the first region of the stack structure and in contact with the cell guide structure;
a protective layer on the second region of the stack structure; and
channel structures each including a first portion and a second portion, the first portion penetrating the stack structure in the vertical direction and the second portion extending upwardly from the first portion and including a channel layer in direct contact with the first conductive layer, the channel structures being on the first region of the stack structure,
wherein a side surface of the first conductive layer and a lower surface of the first conductive layer form an acute angle on an interfacial surface between the first conductive layer and the cell guide structure.

11. The semiconductor device of claim 10, wherein
the cell guide structure has a frame shape on the stack structure, and a region of the frame shape and an internal portion of the frame shape define the first region of the stack structure.

12. The semiconductor device of claim 11, wherein
a thickness of the first conductive layer is greater than a length of the second portion of the channel structures, and
an area of an upper surface of the first conductive layer is smaller than an area of a lower surface of the first conductive layer in the first region of the stack structure.

13. The semiconductor device of any of claims 10 to 12, further comprising:
dummy channel structures penetrating the stack structure in the vertical direction and
extending into a lower portion of the cell guide structure.

14. The semiconductor device of claim 13, further comprising:
a channel dielectric layer covering a channel layer of the second portion of the channel structures.

15. A data storage system, comprising:
a semiconductor storage device including
a first semiconductor structure including a substrate and circuit devices on the substrate, and
a second semiconductor structure including a stack structure and an input/output pad,
the stack structure including interlayer insulating layers and gate electrodes stacked in a vertical direction in a first region and a second region of the stack structure,
the stack structure further including channel structures each including a first portion and a second portion, the first portion penetrating the stack structure in the vertical direction in the first region of the stack structure and the second portion extending upwardly from the first portion in the first region, and
the input/output pad being electrically connected to the circuit devices; and
a controller electrically connected to the semiconductor storage device through the input/output pad and configured to control the semiconductor storage device,
wherein the first semiconductor structure further includes a lower interconnection structure electrically connected to the circuit devices and a lower bonding structure connected to the lower interconnection structure,
wherein the second semiconductor structure includes
an upper interconnection structure below the stack structure,
an upper bonding structure connected to the upper interconnection structure and bonded to the lower bonding structure,
a cell guide structure on an upper portion of the stack structure and dividing the first region of the stack structure and the second region of the stack structure,
contact plugs penetrating the stack structure in the vertical direction and being connected to contact regions of the gate electrodes in the second region of the stack structure,
a first conductive layer in contact with an internal side surface of the cell guide structure in the first region of the stack structure, the first conductive layer on an upper portion of the stack structure and connected to the second portion of the channel structure, and
a protective layer in contact with an external side surface of the cell guide structure in the second region of the stack structure, the protective layer being on the upper portion of the stack structure.
